(19) Europäisches Patentamt / European Patent Office / Office européen des brevets

(11) **EP 3 635 992 B1**

(12) **EUROPÄISCHE PATENTSCHRIFT**

(45) Veröffentlichungstag und Bekanntmachung des Hinweises auf die Patenterteilung:
**14.04.2021 Patentblatt 2021/15**

(21) Anmeldenummer: **18782302.6**

(22) Anmeldetag: **17.09.2018**

(51) Int Cl.:
*H04W 24/00* (2009.01)  *G01S 13/76* (2006.01)
*G01S 13/46* (2006.01)

(86) Internationale Anmeldenummer:
**PCT/EP2018/000434**

(87) Internationale Veröffentlichungsnummer:
**WO 2019/052685 (21.03.2019 Gazette 2019/12)**

(54) **VERFAHREN FÜR FUNKMESSANWENDUNGEN**

METHOD FOR RADIO MEASURING APPLICATIONS

PROCÉDÉ POUR DES APPLICATIONS DE MESURE RADIO

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.09.2017 DE 102017008647**
**15.09.2017 US 201762559116 P**

(43) Veröffentlichungstag der Anmeldung:
**15.04.2020 Patentblatt 2020/16**

(73) Patentinhaber: **Metirionic GmbH**
**01069 Dresden (DE)**

(72) Erfinder: **EGGERT, Dietmar**
**01219 Dresden (DE)**

(74) Vertreter: **Koch Müller**
**Patentanwaltsgesellschaft mbH**
**Maaßstraße 32/1**
**69123 Heidelberg (DE)**

(56) Entgegenhaltungen:
**EP-A1- 2 244 098    EP-A1- 3 067 712**
**WO-A1-2005/119379    WO-A2-02/01247**

**Beschreibung**

Die Erfindung betrifft ein Verfahren für Funkmessanwendungen mit wenigstens zwei Funkknoten zur Ermittlung einer Transferfunktion und/oder eines Zeitversatzes zwischen den Funkknoten.

Es gibt eine Vielzahl von Verfahren zur Abstandsermittlung auf Basis der Messung von Phasen und Phasen-Differenzen von Referenz-Signalen im Frequenzbereich. Das Grundprinzip ist seit mehr als 50 Jahren bekannt, z.B. aus der US 3 243 812. Das Verfahren wird seit Jahrzehnten in Verschiedenen Applikation angewandt. Neben einer Vielzahl von Publikation gibt es auch eine ganze Reihe von Patenten.

Aus der DE 10 2009 060 505 B4 ist ein Verfahren zur Kommunikation zwischen zwei Funkknoten bekannt, wobei die Funkknoten wechselseitig Signale senden und empfangen und die Trägerfrequenzen der Signale für jede Wiederholung geändert werden. Die von dem zweiten Funkknoten extrahierten Phasenwerte werden im Anschluss an den ersten Funkknoten rückübertragen und dann mit den empfangenen Signalen des ersten Funkknoten ausgewertet, um einen Abstand zwischen den beiden Funkknoten zu bestimmen.

Aus der DE 10 2009 060 593 A1 ist ein weiteres Verfahren zur Entfernungsmessung zwischen zwei Funkknoten bekannt, wobei die Funkknoten unmodulierte Trägersignale austauschen, jeder Funkknoten zwei Phasenwerte für zwei Frequenzen ermittelt und aus den insgesamt vier Phasenwerten die Entfernung zwischen den Funkknoten bestimmt wird.

Alternative Verfahren zur Entfernungsmessung zwischen zwei Funkknoten sind aus der DE 10 2009 060 592 B4, der DE 10 2009 060 591 A1 und der WO 02/01247 A2 bekannt.

Aus der WO 2005/119379 A1 ist ein Verfahren zur Korrektur von Jitter bekannt, wobei ein erster Funkknoten auf ein ausgesandtes Initialsignal ein Antwortsignal von einem zweiten Funkknoten erhält und das Antwortsignal sowohl den von dem zweiten Funkknoten ermittelten Empfangszeitpunkt des Initialsignals sowie den Sendezeitpunkt des Antwortsignals selbst enthält.

Vor diesem Hintergrund besteht die Aufgabe der Erfindung darin, ein Verfahren anzugeben, das den Stand der Technik weiterbildet. Die Aufgabe wird durch ein Verfahren für Funkmessanwendungen mit den Merkmalen des Patentanspruchs 1 gelöst. Vorteilhafte Ausgestaltungen der Erfindung sind Gegenstand der Unteransprüche.

Es wird ein Verfahren für Funkmessanwendungen vorgeschlagen, wobei wenigstens zwei Funkknoten bereitgestellt werden.

Mindestens ein erster Funkknoten arbeitet als Initiator und mindestens ein zweiter Funkknoten arbeitet als Transponder.

Der erste Funkknoten und der zweite Funkknoten weisen jeweils einen Zeitgeber und eine Datenschnittstelle auf.

Zwischen den Zeitgebern des ersten Funkknotens und des zweiten Funkknotens besteht ein Zeitversatz.

In einem ersten Schritt wird von dem Initiator eine erste Trägerfrequenz als ein Initialsignal gesendet und von dem Transponder während eines ersten Empfangszeitraums das Initialsignal empfangen.

In einem zweiten Schritt wird von dem Transponder mit einer zweiten Trägerfrequenz ein Antwortsignal gesendet und von dem Initiator während eines zweiten Empfangszeitraums das Antwortsignal empfangen.

Eine Schrittfolge aus dem ersten Schritt und dem zweiten Schritt in der genannten Reihenfolge wird wenigstens einmal wiederholt, wobei das Initialsignal und das Antwortsignal zumindest während jeder Schrittfolge kohärent sind.

Die Trägerfrequenz des Initialsignals und die Trägerfrequenz des Antwortsignals werden bei jeder Wiederholung innerhalb eines vorbestimmten Frequenzbereichs geändert.

Das Verfahren umfasst einen ersten Modus und einen zweiten Modus.

In dem ersten Modus wird das Antwortsignal zumindest aus einem Teil des empfangenen Initialsignals gebildet und eine Transferfunktion und/oder der Zeitversatz anhand zumindest eines Teils der empfangenen Antwortsignale ermittelt.

In dem zweiten Modus wird das Antwortsignal unabhängig von dem empfangenen Initialsignal gebildet und mindestens zwei empfangene Initialsignale werden mittels der Datenschnittstelle übermittelt und mindestens eine Transferfunktion und/oder der Zeitversätze anhand zumindest eines Teils der empfangenen Antwortsignale und zumindest eines Teils der empfangenen und übermittelten Initialsignale ermittelt.

Es versteht sich, dass jeder Funkknoten eine Empfangseinheit, eine Sendeeinheit, einen Signalprozessor, eine Datenschnittstelle und wenigstens eine Antenne umfasst. Des Weiteren versteht es sich, dass in einem Schritt jeweils nur ein Funkknoten sendet.

Es sei angemerkt, dass der Ausdruck Zeitbasis und der Ausdruck Zeitdomäne synonym verwendet werden.

Umfasst ein Funkknoten mehrere Antennen, so wird das Initialsignal und/oder das Antwortsignal von einer der Antennen gesendet oder das Initialsignal und/oder das Antwortsignal wird von mehreren Antennen abgestrahlt. Beispielsweise strahlen die Antennen während eines Sendezeitraums sequentiell nacheinander ab. Der Sendezeitraum ist hierfür z.B. in mehrere Zeitfenster unterteilt, wobei jeweils eine der Antennen während eines Zeitfensters sendet. Es versteht sich, dass auch der Empfang der Signale entsprechend organisiert sein kann.

Alle mit dem erfindungsgemäßen Verfahren übermittelten Werte bzw. Signalvektoren können durch geeignete Verschlüsselungsmechanismen manipuliert werden, um die ablaufenden Vorgänge entsprechend zu schützen. So kann beispielsweise jeder Signalvektor mit einem zeitlich veränderlichen Zahlenfolge belegt werden, der nur dem Initiator und dem Transponder a priori bekannt sind.

Die Datenschnittstelle ist gemäß alternativer Ausführungsformen drahtgebunden oder drahtlos ausgebildet und ermöglicht den Austausch von Daten, z.B. von ermittelten Signalvektoren, sowie die grobe Synchronisation der Funkknoten.

Als Initiator wird ein Funkknoten bezeichnet, der in einem ersten Schritt ein Signal aussendet.

Als Transponder wird ein Funkknoten bezeichnet, der das in einem ersten Schritt ausgesendete Signal empfängt und verarbeitet. Erst in einem zweiten Schritt sendet der Transponder ein Antwortsignal zurück.

Mittels des Verfahrens lassen sich ein Zeitversatz zwischen den einzelnen Zeitgebern und/oder eine Transferfunktion bestimmen. Voraussetzung ist, dass eine Kohärenz zwischen den Signalen des ersten Schritts und den Signalen des zweiten Schritts besteht.

Die Transferfunktion bildet die Übertragungseigenschaften zwischen zwei Funkknoten im Frequenzbereich ab, also die Übertragung eines Signals über ein Ausbreitungsmedium, und stellt im Bereich der drahtlosen Datenübertragung eine übliche Bezeichnung dar. Vielfach wird die Transferfunktion auch als Übertragungsfunktion bezeichnet.

Es versteht sich, dass sich mittels einer Fourier-Transformation die aufgenommen Werte aus dem Frequenzbereich in den Zeitbereich transformieren lassen. Im Zeitbereich ist für das Übertragungsverhalten eines Ausbreitungsmediums auch der Begriff Kanalimpulsantwort üblich.

Das Verfahren umfasst einen ersten und einen zweiten Modus, wobei jeder Modus für sich geschlossen ist. Maßgeblich für Modus 1 ist, dass innerhalb des Signalaustauschs zusätzliche Informationen innerhalb des Messsignals übermittelt werden, während Modus 2 ausschließlich die Datenschnittstelle für die Übertragung dieser Informationen nutzt. Ein System arbeitet jeweils innerhalb eines Zeitraums in einem der Modi. Ein Übergang zwischen den Modi ist möglich.

Mittels des Verfahrens ist es möglich, eine Übertragungsfunktion für das Ausbreitungsverhalten eines Ausbreitungsmediums von dem Initiator zu dem Transponder oder von dem Transponder und zu dem Initiator (auch als 1WR-Einwegtransferfunktionen bezeichnet) oder für einen Umlauf, also eine Übertragung von dem Initiator zu dem Transponder und von dem Transponder zu dem Initiator zurück (auch als 2WR-Umlauftransferfunktion bezeichnet) zu bestimmen.

Aus der ermittelten Transferfunktion im Frequenzbereich lässt sich wiederum der Abstand zwischen den beteiligten Funkknoten bestimmen.

Dabei kommt insbesondere dem Phasengang zwischen den Signalen eine besondere Bedeutung zu. Wird das Ausbreitungsverhalten innerhalb eines Mediums von dem direkten Pfad dominiert, dann lässt sich aus dem Phasengang über eine Ableitung die Gruppenlaufzeit $t_g$ der elektromagnetischen Welle ermitteln.

$$t_g = \frac{d\varphi}{d\omega}$$

Über die Ausbreitungsgeschwindigkeit c der elektromagnetischen Welle entsteht eine direkte Beziehung zu dem Abstand d zwischen den Funkknoten entsprechend $d = c \cdot t_g$.

Kennzeichnend für alle Messverfahren ist das wechselseitige Senden eines Referenzsignals, also des Initialsignals bzw. des Antwortsignals, das vom anderen Knoten empfangen wird, wobei dabei die Lage des Empfangssignals in der komplexen Ebene bzgl. seiner internen Zeitreferenz bewertet wird.

Eine Schrittfolge aus dem ersten Schritt und dem zweiten Schritt stellt eine Kernoperation dar, die auch als Atomic Operation oder als Ping-Pong bezeichnet wird.

Die Phasenkohärenz muss im Minimum über eine Schrittfolge erhalten sein.

Der Übertragungskanal ist in vielen Fällen durch mehrere Wege gekennzeichnet, wobei neben der direkten Verbindung zwischen zwei Funkknoten auch weitere Pfade durch Reflexion an Gegenständen und/oder durch Brechung und/oder durch Beugung entstehen können.

Um mehrere Wege in den empfangenen Signalen aufzulösen wird die Schrittfolge, also das wechselseitige Senden und Empfangen von Referenzsignalen, in Frequenzschritten über eine Bandbreite (vorbestimmten Frequenzbereich) mehrfach wiederholt. Hierdurch lässt sich die Transferfunktion basierend auf einer Menge von Stützstellen im Frequenzbereich ermitteln.

Die Bandbreite des vorbestimmten Frequenzbereichs ist bestimmend für die Fähigkeit des Verfahrens, Signal-Pfade mit unterschiedlichen Längen aufzulösen. Da es sich um eine frequenz-diskrete Darstellung handelt, bestimmt die Frequenzschrittweite den Bereich über den sich ein Abstand eindeutig ermitteln lässt und begrenzt gleichzeitig die Größe der eindeutig bestimmbaren Zeitversätze.

Eine Vielzahl von Schrittfolgen wird als Messzyklus bezeichnet. Die Zeitdauer des Messzyklus ist von der Anzahl, Art und Zeitdauer der einzelnen Schrittfolgen und der verwendeten Frequenzen abhängig.

Die Erhaltung der Phasenkohärenz der Signale über einen abgegrenzten Zeitraum und zwischen Funkknoten ist eine wichtige Eigenschaft des Verfahrens und eine Voraussetzung für eine Rekonstruktion des Signalverlaufs.

Die Kohärenz-Forderung ist je nach Ausführung auf mehrere Schrittfolgen, also einen Messzyklus oder auch mehrere Messzyklen auszuweiten.

Neben dem Abstand ist auch eine Extraktion von weiteren Parametern, z.B. einem Einfallswinkel zwischen Funkknoten (zwei oder mehrere) für eine relative Positionsbestimmung, möglich. Dazu sind die Empfangssignale mehrerer Antennen auszuwerten bzw. die Sendesignale auf mehrere Antennen determiniert zu verteilen. Dies kann parallel/gleichzeitig durch Nutzung mehrerer Sende- und Empfangseinheiten erfolgen. Alternative kann auch die Antennenzuordnung zeitlich nacheinander auf verschiedenen Zeitfenstern innerhalb der Schrittfolge und durch Umschalten der Antennen zwischen den Zeitfenstern erfolgen. Beim Umschalten sind entsprechende Einschwingvorgänge zu beachten.

Vorzugsweise entspricht der vorbestimmte Frequenzbereich beispielsweise dem zur Verfügung stehenden Frequenzbereich, richtet sich also nach den von den verwendeten Funkknoten zur Verfügung gestellten Bandbreiten. Alternativ wird der technisch mögliche Frequenzbereich aufgrund gesetzlicher Vorgaben und/oder aufgrund einer konkreten Anwendung eingeschränkt, so dass der vorbestimmte Frequenzbereich nur einen Teilbereich des zur Verfügung stehenden Frequenzbereichs umfasst.

Jeder Funkknoten folgt einem festen zeitlichen Ablauf, der fest an den Zeitgeber und die entsprechende Zyklussteuerung gebunden und daher deterministisch ist. Damit haben alle Funktionsblöcke über die erforderlichen Zeiträume einen festen Zeit- und Phasenbezug und erfüllen die jeweiligen Forderungen nach Phasenkohärenz. Da das Zeitverhalten der Funkknoten unter den Knoten a-priori (mit Ausnahme von Initialphasenlage, Zeit- und Frequenzoffset) bekannt ist, entsteht eine Kohärenzbeziehung zwischen den Funkknoten.

Für den Ablauf des Verfahrens ist es jedoch wichtig, dass die entsprechenden Sende- und Empfangszeiträume (ggfs. auch Sende- und Empfangszeitfenster) sich gegenüberstehen und entsprechende Einschwingvorgänge abgeschlossen sind, d.h. ein stationärer Zustand hergestellt wird.

Die tolerierbare Schwankung des Zeitversatzes, die durch eine GrobSynchronisation abgesichert wird, orientiert sich an der Größe des Messbereichs und sollte z.B. bei einem Messbereich von 300m geringer als 1μs sein um erhöhte Aufwände in Zeit- und Frequenzoffsetkorrektur zu vermeiden. Die erreichbare Messgenauigkeit im 2.4GHz Bereich liegt bei unter einem 1m.

Bzgl. dieser Eigenschaft unterscheidet sich dieses Verfahren maßgeblich von etablierten UWB TDOA (Time Difference of Arrival) Verfahren. Da hier die Messgenauigkeit durch die Synchronisation bestimmt wird, muss die Synchronisationsgüte bei vergleichbarer Genauigkeit besser als 3ns sein.

Wie angemerkt, verfügt jeder Funkknoten über eine eigene Zeitreferenz. Vorzugsweise ist die Zeitreferenz als Quarzoszillator (XTAL/XOSC) ausgebildet. Es versteht sich, dass der grobe Zeitabgleich nicht die Ermittlung des tatsächlichen Zeitoffsets bei einer Kernoperation ersetzt, sondern eine Voraussetzung ist.

Ein Vorteil ist, dass sich die Flexibilität des Verfahrens und die Zuverlässigkeit erhöht. Ein anderer Vorteil ist, dass sich das Verfahren schneller und kostengünstiger durchführen lässt. Insbesondere lässt sich das Verfahren vorteilhaft bei Ermittlung der Position von Funkknoten im Bereich der Sensornetzwerke einsetzen. Des Weiteren erlaubt das Verfahren hochauflösende Abstandsmessungen in großen Reichweitenbereichen, d.h. in einem Bereich von 0.5 m bis 10 Km, durchzuführen. Insbesondere mittels der Verwendung von Schmalbandarchitekturen, d.h. Kanalfilterbandbreite kleiner 1MHz, werden ein hoher Dynamikbereich und eine hohe Störfestigkeit erreicht.

Die Ermittlung des Zeitoffsets bzw. des Zeitversatzes zweier an der Kommunikation beteiligter Funkknoten ist für eine Weiterverarbeitung der Messergebnisse von Bedeutung.

In einer Weiterbildung lässt sich der Zeitversatz auch für die Synchronisation von Einheiten eines Systems verwenden und besitzt daher eine wichtige Bedeutung.

Als Datenschnittstelle wird jede weitere Art eines Datenaustauschs bezeichnet, also beispielsweise ein Kommunikationsprotokoll für einen drahtlosen Austausch, z.B. Bluetooth, Zigbee oder IEEE 802.11, welches einen Austausch von Dataframes zur groben Synchronisation ermöglicht. Alternativ kann die Datenschnittstelle als eine Datenleitung bzw. Anschluss für eine Datenleitung ausgebildet sein.

Wird gemäß dem ersten Modus das Antwortsignal zumindest aus einem Teil des empfangenen Initialsignals gebildet, so werden entsprechend Informationen über das empfangene Initialsignal direkt an den Initiator zurück übermittelt. Das empfangene Antwortsignal enthält somit Informationen über Hin- und Rückweg zwischen den Funkknoten. Dies ermöglicht es, allein anhand der empfangenen Antwortsignale die 2WR-Transferfunktion zu ermitteln.

Wird gemäß dem zweiten Modus das Antwortsignal unabhängig von dem Initialsignal gebildet, so wird gemäß einer ersten alternativen Ausführungsform mindestens ein von dem Transponder ermittelter Empfangssignalvektor mittels der Datenschnittstelle an den Initiator übermittelt. So kann die weitere Auswertung von dem Initiator oder einer mit dem Initiator kommunizierenden Recheneinheit vorgenommen werden.

Anhand der empfangenen Antwortsignale und der empfangene und übermittelten Initialsignale kann die 2WR-Transferfunktion ermittelt werden.

Der Zeitversatz lässt sich anhand von mindestens zwei empfangenen Initialsignalen und mindestens zwei empfangenen Antwortsignalen bestimmen. Die Ermittlung des Zeitversatzes ist eine notwendige Voraussetzung für die Bestimmung der 1WR-Transferfunktion.

Die Bestimmung des Zeitversatzes ist sowohl in dem ersten Modus als auch in dem zweiten Modus möglich.

Ein Vorteil des erfindungsgemäßen Verfahrens ist somit, dass eine weitere Datenübermittlung aller oder zumindest vieler Messergebnisse des Transponders entfällt. Hierdurch kann sowohl der technische als auch der zeitliche Aufwand reduziert werden.

Gemäß einer ersten Ausführungsform entspricht die zweite Trägerfrequenz der ersten Trägerfrequenz. Alternativ unterscheidet sich die zweite Trägerfrequenz von der ersten Trägerfrequenz.

Es versteht sich, dass der zeitliche Verlauf der Trägerfrequenzen bzw. die Frequenzänderungen den beteiligten Funkknoten vorab bekannt sind. Die zweite Trägerfrequenz wird beispielsweise immer der ersten Trägerfrequenz entsprechend geändert. Die Änderung der zweiten Trägerfrequenz erfolgt alternativ unabhängig von der Änderung der ersten Trägerfrequenz oder gar nicht.

Die Änderung, d.h. der bei einer Wiederholung vorgenommene Frequenzschritt, ist bei jeder Wiederholung gleich oder ändert sich bei jeder Wiederholung, beispielsweise gemäß einer vorgegebenen allen Funkknoten bekannten Liste oder mathematischen Funktion, die auch das zeitliche Verhalten einschließt und damit die erforderliche Phasenkohärenz erhalten werden kann.

Gemäß einer Weiterbildung wird ein Messzyklus von mehreren Wiederholungen der Schrittfolge gebildet und das Initialsignal und das Antwortsignal sind mindestens während eines Messzyklus oder mindestens während mehrerer Messzyklen kohärent. Die zueinander kohärenten Messzyklen sind insbesondere bei Nutzung mehrerer Antennen innerhalb eines Funkknotens und/oder weiterer Funkknoten vorteilhaft.

In einer Ausführungsform wird aus dem empfangenen Initialsignal ein erster komplexer Signalvektor (Empfangssignalvektor) ermittelt, wobei das Antwortsignal aus dem ersten komplexen Signalvektor oder alternativ aus dem reziproken ersten komplexen Signalvektor gebildet wird.

In einer ersten Alternative entspricht das von dem Initiator empfangene Antwortsignal einer frequenzweisen Multiplikation des komplexen Signalvektors mit der Kanaltransferfunktion des Ausbreitungsmediums. Im Ergebnis entsteht das im Frequenzbereich diskret abgetastete Quadrat der Kanaltransferfunktion. Im Zeitbereich entspricht ergibt sich hieraus die zeitdiskret abgetastete Faltung der Kanalimpulsantwort mit sich selbst.

In einer zweiten Alternative liefert das von dem Initiator empfangene Antwortsignal einem Verzögerungsoperator $e^{j\omega \cdot 2 \cdot T_{off}}$, der die Ermittlung des Zeitversatz zwischen den beiden Funkknoten erlaubt. Mit Hilfe des Zeitversatzes lässt sich die 1WR-Kanaltransferfunktion ermitteln.

Weiterhin kann der ermittelte Zeitversatz auch als Stellgröße innerhalb von Präzisionssynchronisationen und auch zum Test einer zeitlichen Synchronisation von Funktionsblöcken verwendet werden.

In einer anderen Ausführungsform wird ein erster komplexer Signalvektor ermittelt und das Antwortsignal aus dem konjugiert komplexen ersten komplexen Signalvektor gebildet wird.

Das empfangene Antwortsignal besteht aus dem Betragsquadrat des ersten komplexen Signalvektors sowie einem Verzögerungsoperator $e^{j\omega \cdot 2 \cdot T_{off}}$, der den Zeitversatz zwischen den Knoten gekennzeichnet.

Gemäß weiterer alternativer Ausführungsform wird aus dem empfangenen Initialsignal eine erste Phase ermittelt, wobei das Antwortsignal entweder aus der ersten Phase oder aus der invertierten ersten Phase gebildet wird. Diese Alternativen sind besonders einfach und schnell.

In anderen alternativen Ausführungsformen arbeitet immer mindestens ein Funkknoten als Initiator und immer mindestens ein Funkknoten als Transponder, wobei jeder Funkknoten über mehrere Schrittfolgen mindestens einmal als Initiator und mindestens einmal als Transponder arbeitet oder jeder Funkknoten über mehrere Schrittfolgen nur als Initiator oder nur als Transponder arbeitet.

In einer weiteren Ausführungsform wird ein Messzyklus von mehreren Wiederholungen der Schrittfolge gebildet und die erste Trägerfrequenz nimmt für jede Wiederholung während des Messzyklus jeweils einen vorbestimmten Wert innerhalb des Frequenzbereichs an.

Beispielsweise wird ein Frequenz-Sweep durchgeführt, wobei die erste Trägerfrequenz bei jeder Wiederholung während des Messzyklus jeweils um einen konstanten Wert innerhalb des vorgegebenen Frequenzbereichs erhöht oder verringert wird. Ein Sweep ist mit geringem Implementierungsaufwand umsetzbar. In der Regel ist es einfacher die Phasenbeziehungen über eine Vielzahl kleinerer Frequenzschritte aufrechtzuerhalten. Auf Grund von gesetzlichen Bestimmungen ist diese Ausführung jedoch für viele Anwendungen in der zulässigen Sendeleistung beschränkt.

Eine unregelmäßigere Änderung der Frequenz wird auch als Frequenz-Hopping bezeichnet. Die unterschiedlichen Frequenzen bzw. Werte für die Trägerfrequenz für jede einzelne Wiederholung sind beispielsweise in einem Lookup-Table hinterlegt oder richten sich nach einer vorgegebenen mathematischen Funktion. Beispielsweise kann das Frequenz-Hopping auf Basis von pseudorauschartigen Folgen durchgeführt werden, wodurch eine hohe Robustheit gegen Störquellen erreicht wird. Gleichzeitig erlaubt diese Ausführung des Verfahrens die Nutzung größerer Sendeleistungen bei Einhaltung der verschiedensten gesetzlichen Bestimmungen und regulatorische Vorgaben. Somit ist es möglich die Nutzung des Verfahrens auf größere Reichweiten zu erweitern.

In einer anderen Ausführungsform wird anhand der ermittelten Transferfunktion und/oder des Zeitversatzes ein Abstand zwischen dem mindestens einen Initiator und dem mindestens einen Transponder bestimmt.

Gemäß einer Weiterbildung wird für mindestens eine ermittelte Kanaltransferfunktion eine Mehrwege-Analyse durchgeführt. Die Mehrwegeanalyse fokussiert sich auf die Ermittlung des direkten Ausbreitungsweges.

Gemäß einer anderen Weiterbildung wird vor der Ermittlung der Transferfunktion und/oder des Zeitversatzes auf die empfangenen Antwortsignale und/oder die empfangenen Initialsignale ein Filter angewandt. Als Filter kann beispielsweise ein $\cos^2$-Fenster zur Unterdrückung von Nebenmaxima eingesetzt werden. Eine höhere Messdynamik bzw. Rauschunterdrückung kann beispielsweise durch Mittelwertsbildung der Messwerte innerhalb einer Schrittfolge erfolgen.

In einer weiteren Weiterbildung werden bei jeder Wiederholung zusätzlich zu der Trägerfrequenz des Initialsignals eine Amplitude und/oder eine Phase des Initialsignals verändert.

Gemäß einer anderen Weiterbildung werden mindestens drei Funkknoten bereitgestellt und in jeder Schrittfolge wird der zweite Schritt mindestens einmal wiederholt, wobei in dem ersten Schritt das Initialsignal von mindestens zwei als Transponder fungierenden Funkknoten empfangen wird, in jedem zweiten Schritt von genau einem der Transponder das Antwortsignal gesendet und von dem Initiator sowie von mindestens einem weiteren Transponder empfangen wird, bei jeder Wiederholung des zweiten Schritts ein anderer Transponder das Antwortsignal sendet und in dem ersten Modus bei jeder Wiederholung des zweiten Schritts das Antwortsignal jeweils zumindest aus einem Teil des empfangenen Initialsignals oder aus einem Teil des empfangenen Antwortsignals gebildet wird.

In einer weiteren Ausführungsform sendet der Initiator das Initialsignal während eines ersten Sendezeitraums und der Transponder sendet das Antwortsignal während eines zweiten Sendezeitraums, wobei der erste Sendezeitraum und der zweite Sendezeitraum jeweils mehrere, aufeinanderfolgende Zeitfenster umfassen, jeweils nur während der Zeitfenster gesendet wird und jeweils zwei aufeinanderfolgende Zeitfenster zeitlich unmittelbar aufeinander folgen oder zeitlich einen Abstand zueinander aufweisen.

Es versteht sich, dass auch die Empfangszeiträume mehrere Zeitfenster umfassen können, wobei die Zeitfenster der Sendezeiträume und die Zeitfenster der Empfangszeiträume einander (bis auf den Zeitversatz) entsprechen können, aber nicht müssen.

Diese Vorgehensweise erlaubt insbesondere die Anpassung an verschiedenen Applikationsanpassungen, wie getrennte Übertragung der Referenzphase, Signalisierung zwischen Initiator und Transponder (Verstärkungs- und Sendeleistungsanpassungen, Verschlüsselung), Rauschunterdrückung durch Mittelwertbildung, Zuordnung zu verschiedenen Antennen zur Erzeugung von Raumdiversität zur Ermittlung von Einfallswinkeln im speziellen und zur Verbesserung der Messgenauigkeit im Allgemeinen (Beam Steering, MIMO, Smart Antennas), oder auch zur Detektion von Kanalbelegungen im Sinne von LBT (Listen-before-Talk), CS (Carrier Sense) und DAA (Detect and Avoid) Anforderungen für die Zulassung von Funksystemen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. Abstände sowie laterale und vertikale Erstreckung sind nicht maßstäblich und weisen, sofern nicht anders angegeben, auch keine ableitbaren geometrischen Relationen zueinander auf. Darin zeigen,

Figur 1 eine Messanordnung für Funkmessanwendungen gemäß einer ersten alternativen Ausführungsform,

Figur 2 ein Ablaufschema der ersten alternativen Ausführungsform,

Figur 3 eine Tabelle mit einem Überblick über verschiedene Sende-, Empfangs-, Basisbandvektoren und den entsprechenden Abhängigkeiten

Figur 4 ein Schema eines ersten zeitlichen Verlaufs des Verfahrens für Funkmessanwendungen gemäß der ersten alternativen Ausführungsform,

Figur 5 ein Schema eines weiteren zeitlichen Verlaufs des Verfahrens für Funkmessanwendungen gemäß der ersten alternativen Ausführungsform,

Figur 6 eine Messanordnung für Funkmessanwendungen gemäß der zweiten alternativen Ausführungsform,

Figur 7 Amplitudenverläufe der Mess-Signale,

Figur 8 in den Zeitbereich transformierte Mess-Signale,

Figur 9 eine Anordnung von drei Funkknoten,

Figur 10 ein Ablaufschema unter Verwendung von drei Funkknoten.

Für alle Ausführungsformen sei angemerkt, dass:
Ein als Initiator bezeichneter erster Funkknoten FI und ein als Transponder bezeichneter zweiter Funkknoten FT bereitgestellt werden. Der Initiator FI und der Transponder FT weisen jeweils eine Empfangseinheit RX, eine Sendeeinheit TX, eine Datenschnittstelle DS1 bzw. DS2 und einen eigenen Zeitgeber Z(t) bzw. Z(t') auf. Es versteht sich, dass jeder Funkknoten einen Signalprozessor - nicht dargestellt - enthält.

Die Datenschnittstellen DS1 und DS2 sind als Kommunikationsprotokoll für einen drahtlosen Datenaustausch ausgebildet.

Der Initiator-Funkknoten FI besitzt eine Zeitbasis t und der Transponder-Funkknoten FT besitzt eine Zeitbasis t', wobei die beiden Zeitbasen t bzw. t' voneinander unabhängig sind.

Es sei angemerkt, dass der Ausdruck Zeitbasis und der Ausdruck Zeitdomäne synonym verwendet werden.

Die zugehörigen Zeitgeber Z(t) und Z(t') umfassen jeweils einen Quarzoszillator und geben ein Zeitmaß für die jeweilige Zeitbasis t bzw. t' des jeweiligen Funkknotens vor.

Die Zeitgeber Z(t) und Z(t') sind durch einen Zeitversatz $T_{offs}$ gegeneinander verschoben. Es wird vorausgesetzt, dass die Zeitgeber Z(t) und Z(t') in gleichen Einheiten fortschreiten, d.h. es besteht kein Frequenzoffset zwischen den Quarzoszillatoren.

Sollte zwischen den beiden Zeitgebern Z(t) und Z(t') ein Frequenzoffset bestehen, muss der Frequenzoffset korrigiert werden, um das Verfahren durchzuführen. Eine Korrektur des Frequenzoffsets ist nicht Gegenstand der vorliegenden Anmeldung.

Die Zeitgeber Z(t) bzw. Z(t') erzeugen jeweils eine Zeitreferenz für eine Ablaufsteuerung in dem Initiator-Funkknoten FI und dem Transponder-Funkknoten FT. Die Ablaufsteuerung steuert das zeitliche Verhalten aller relevanten Funktionsblöcke in den jeweiligen Funkknoten FI und FT. Insbesondere gibt die Ablaufsteuerung die Zeitpunkte für einen Frequenzwechsel vor. Es sei angemerkt, dass die Ablaufsteuerung auch als Zeit-Frequenzsteuerung ZFS1 und ZFS2 bezeichnet wird.

Es sei angemerkt, dass die zeitlichen Längen $T_{MU}$ bzw. $T_{MU}$ jeweils ein vorgegebenes kleinstes Zeitintervall bezeichnen, wobei das kleinste Zeitintervall auch als Messeinheitszeit $T_{MU}$ bezeichnet wird.

Es sei angemerkt, dass das Verfahren umfasst:

- Schritte ausweisend eine oder mehrere Sendefenster bzw. Empfangsfenster,
- Schrittfolgen umfassend wenigstens zwei Schritte mit einer zeitlichen Länge $T_{SF}$ für den Initiator FI bzw. einer zeitlichen Länge $T_{SF}$ für den Transponder FT,
- Messzyklen als einen Serie von Schrittfolgen mit einer zeitlichen Länge $T_z$ für den Initiator FI bzw. einer zeitlichen Länge $T'_z$ für den Transponder FT,
- Serien von Messzyklen.

Jede Schrittfolge weist Sende und Empfangsbereiche auf, die jeweils in Sendefenster und Empfangsfenster unterteilt sind. Die zeitliche Länge eines Sende- bzw. Empfangsfensters des Funkknoten FI ist $T_{MU}$. Die zeitliche Länge eines Sende- bzw. Empfangsfensters des Funkknoten FT ist $T_{MU}$.

Jeder Funkknoten FI weist ein Sendefenster mit einer zeitlichen Länge $T_{MU}$ und ein Empfangsfenster mit einer zeitlichen Länge $T_{MU}$ auf. Jeder Funkknoten FT weist ein Sendefenster mit einer zeitlichen Länge $T'_{MU}$ und ein Empfangsfenster mit einer zeitlichen Länge $T'_{MU}$ auf.

Es sei angemerkt, dass der Index n innerhalb einer der Schrittfolge die Stellung der Zeitfenster angibt und eine Dauer von $T_{SF}=n_{max}\cdot T_{MU}$ besitzt. Der Index besitzt einen Wertebereich $n=0,1,...(n_{max}-1)$, wobei sich $n_{max}$ aus der konkreten Auslegung des Messzyklus bestimmt.

Der Index m gibt innerhalb des Messzyklus die Stellung der Schrittfolge an, wobei $m=0,1,...(m_{max}-1)$. $m_{max}$ durch die konkrete Ausführung bestimmt wird und ist u.a. von der Anzahl der Frequenzen abhängig, für die die Übertragungsfunktion ermittelt werden soll. Eine Serie von Schrittfolgen wird als Messzyklus bezeichnet. Ein Messzyklus des Funkknoten FI hat eine Länge von $T_z=m_{max}\cdot T_{SF}$. Ein Messzyklus des Funkknoten FT hat eine Länge von $V'_z=m_{max}\cdot T'_{SF}$.

Zur Unterscheidung zwischen Initiator Funkknoten FI und Transponder-Funkknoten FT sind die entsprechenden Größen des Transponders durch Anstriche (z.B. Frequenzen und Zeiten des $f'_p$, $\omega'_p$, t',...) gekennzeichnet.

Nachfolgend wird zwischen zeitkontinuierlichen Größen und zeitdiskreten Größen unterschieden. Insbesondere erzeugen die Sende-Einheiten TX des Initiator-Funkknoten FI bzw. die Sendeeinheiten TX des Transponder-Funkknotens FT zeitkontinuierliche Sendesignale $T_I(t)$ bzw. $T_T(t')$, wobei die Darstellung $T_I(m,n)$ den Wert eines Sendesignals $T_I$ bezüglich der Zeitbasis t zu einem Zeitpunkt $t= n\cdot T_{MU}+m\cdot T_{SF}$. bezeichnet. Entsprechend bezeichnet die Darstellung $T_T(m,n)$ den Wert eines Sendesignals $T_T$ bezüglich der Zeitbasis t' zu einem Zeitpunkt $t'= n\cdot T_{Mu}+m\cdot T'_{SF}$.

Hinsichtlich der Phasenkohärenz wird angemerkt, dass die Sende- und die Empfangseinheit des Transponders zusammen mit dem Zeitgeber Z(t) und der Zeit-Frequenz Ablaufsteuerung eine phasenkohärente Domain bilden.

Die phasenkohärente Domain des Funkknoten FI ist für eine geforderte zeitliche Länge d.h. für eine beliebige Anzahl von Schritten, gekennzeichnet durch eine feste Beziehung zwischen der Phasenlage der Sendesignale $T_I(m,n)$ für alle Indizes n innerhalb einer Schrittfolge, in denen die Sendeeinheit sendet und der Referenzphase für die Ermittlung der Empfangsvektoren $R_I(m,n)$ für alle Indizes n innerhalb einer Schrittfolge, in denen die Empfangseinheit empfängt.

Analog gilt für den Transponder, dass die phasenkohärente Domain des Funkknoten FT für eine geforderte zeitliche Länge d.h. für eine beliebige Anzahl von Schritten, durch eine feste Beziehung zwischen der Phasenlage der Sendesignale $T_I(m,n)$ für alle Indizes n innerhalb einer Schrittfolge, in denen die Sendeeinheit sendet und der Referenzphase für die Ermittlung der Empfangsvektoren $R_I(m,n)$ für alle Indizes n innerhalb einer Schrittfolge, in denen die Empfangseinheit empfängt, gekennzeichnet ist.

Ist die Phasenkohärenz auf eine Schrittfolge begrenzt, so beträgt die Kohärenz Länge $T_{SF}$ für den Funkknoten FI bzw. $T_{SF}$ für den Funkknoten FT. Wird die Phasenkohärenz auf einen Messzyklus ausgedehnt so ist für den Funkknoten FI die Kohärenzlänge $T_Z$ bzw. für den Funkknoten FT ist die Kohärenzlänge $T_{Z'}$.

Bei einer Serie von Messzyklus verlängert sich die Kohärenzlänge entsprechend auf die zeitliche Länge der Serie von Messzyklen.

Es versteht sich, dass die Übergangsbereiche, die durch Einschwingvorgänge gekennzeichnet sind, von der Forderung nach Kohärenz ausgenommen sind.

Aus den Anforderungen bzgl. Phasenkohärenz der jeweiligen Funkknoten ergibt sich eine Phasenkohärenz der Funkknoten zueinander, wenn die sich die Zeitgeber nur in einem Zeitversatz unterscheiden und ansonsten beide Knoten dem gleichen zeitlichen Ablauf auf Basis $T_{MU}$, bzw. $T_{MU}$ folgen, der Empfangs-und Sendeverhalten zueinander komplementär ist.

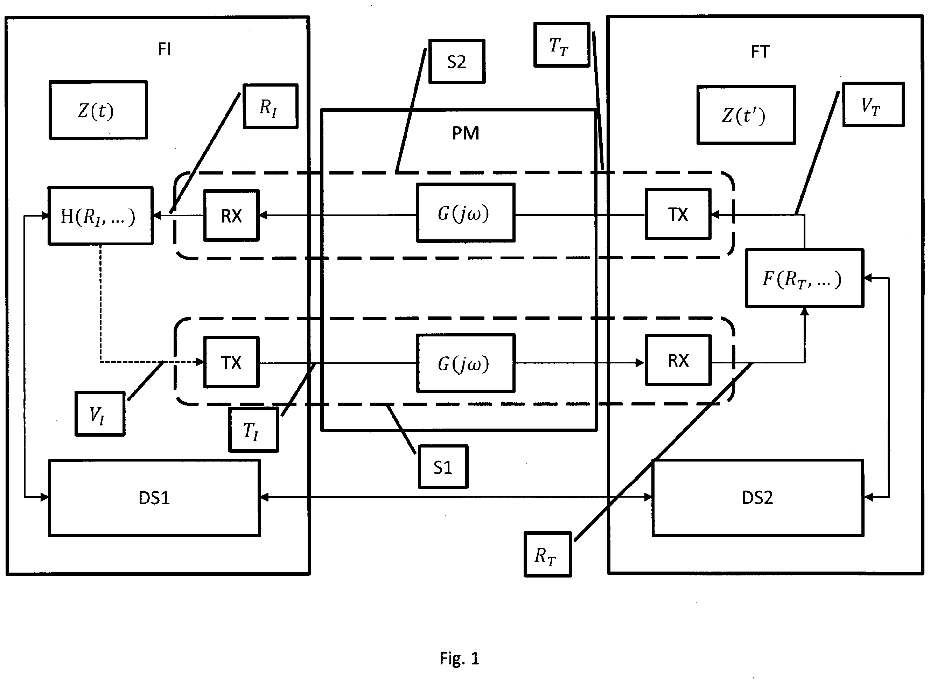

Die Abbildung der Figur 1 zeigt eine Anordnung von zwei Funkknoten, dem Initiator FI und dem Transponder FT, zur Durchführung einer ersten Ausführungsform eines erfindungsgemäßen Verfahrens für Funkmessanwendungen, wobei die Anordnung dazu ausgelegt ist, einen ersten Modus des erfindungsgemäßen Verfahrens auszuführen.

Der Initiator FI ist dazu ausgelegt während eines ersten Schritt S1 mittels der Sendeeinheit TX über ein Ausbreitungsmedium PM, z.B. Luft, ein Initialsignal $T_I$ zu senden. Der Transponder FT ist dazu ausgelegt während des ersten Schritts S1 das von dem Initiator FI ausgesandte Initialsignal $T_I$ nach einer Übertragung über das Ausbreitungsmedium PM als Empfangssignal $R_T$ zu empfangen.

Die Empfangseinheiten RX des Initiator Funkknotens FI und RX des Transponder Funkknotens FT überführen die empfangenen Signale in eine zeitdiskrete Darstellung. Die Empfangsergebnisse $R_I$ und $R_T$ werden weiterhin als Empfangsvektoren bezeichnet.

Die Empfangsvektoren $R_T(m,n)$ haben die Form einer komplexen Zahl, wobei der Betrag proportional zum Betrag des empfangenen Signals ist.

Die Phase der komplexen Vektoren $R_T(m,n)$ wird relativ zur Zeitbasis t' zu den Zeitpunkten $t'=n \cdot T'_{MU}+m \cdot T'_{SF}$ bestimmt.

Außerdem ist der Transponder FT dazu ausgelegt, aus dem Empfangssignal $R_t$ mit Hilfe einer Funktion $F(R_T,..)$ einen Signalvektor $V_T$ zu ermitteln und mittels der Datenschnittstelle DS2 auszutauschen.

Um den ersten Modus des erfindungsgemäßen Verfahrens ausführen zu können, ist der Transponder FT zusätzlich dazu ausgelegt, den Signalvektor $V_T$ an die Sendeeinheit TX zu übermitteln und mittels der Sendeeinheit TX weiter zu verarbeiten.

Während eines zweiten Schritts S2 sendet der Transponder FT mittels der Sendeeinheit TX ein Antwortsignal $T_T$.

Der Initiator FI empfängt während des zweiten Schritts S2 mittels der Empfangseinheit RX das von dem Transponder ausgesandte Antwortsignal $T_T$ nach Übertragung über das Ausbreitungsmedium PM als Empfangssignal $R_I$.

Die Empfangsvektoren $R_I(n,m)$ des Initiators haben die Form einer komplexen Zahl, wobei der Betrag proportional zum Betrag des empfangenen Signals ist. Die Phase der komplexen Vektoren $R_I(m,n)$, wird relativ zur Zeitbasis t zu den Zeitpunkten $t=n \cdot T_{MU}+m \cdot T_{SF}$ bestimmt.

Außerdem ist der Initiator FI dazu ausgelegt, aus dem Empfangssignal $R_I$ mit Hilfe der Funktion $H(R_I,..)$ Signalvektor $V_I$ zu ermitteln und mit der Datenschnittstelle DS1 auszutauschen.

Der Einfluss der Übertagung über das Ausbreitungsmedium PM auf die ausgesandten Signale wird als Transferfunktion G bezeichnet.

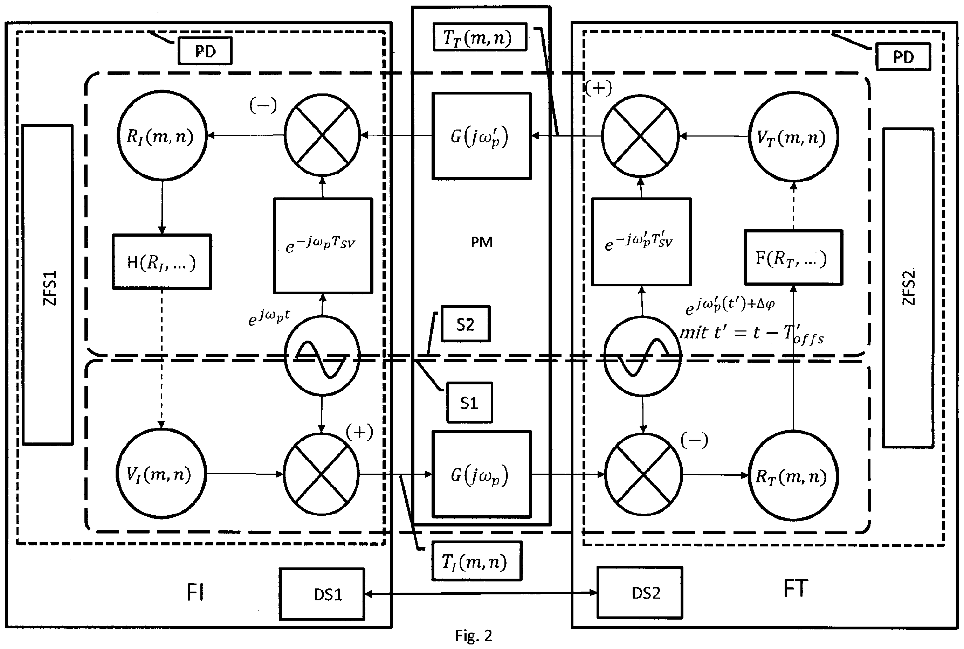

Ein Verfahrensablauf gemäß der ersten alternativen Ausführungsform des Verfahrens für Funkmessanwendungen wird im Folgenden anhand der Figuren 2, 3 und 4 weiter erläutert.

Wie Figur 2 zeigt, besitzen beide Funkknoten FI und FT jeweils einen Generator, eine Aufwärtsmischer, der einen komplexen Signalvektor VT bzw. VI aus der Basisband-Lage in die HF-Lage konvertiert, einen Abwärtsmischer, der ein Hochfrequenzsignal in einen Signalvektor RI bzw. RT in der Basisbandlage konvertiert und eine den Zeitgeber Z(t) bzw. Z(t') beinhaltende Zeit- und Frequenzsteuerung ZFS1 bzw. ZFS2, die alle Systemzustandswechsel in einem festen Zeitregime steuert.

Die Zeit- und Frequenzsteuerung ZFS1 bzw. ZFS2 arbeitet auf Basis einer Zeiteinheit $T_{MU}$ und stellt sicher das alle relevanten Zustandswechsel (Sampling der Signalvektoren, RX/TX-TX/RX Übergänge, Frequenzwechsel fest mit der durch den jeweiligen Zeitgeber vorgegebenen Zeitbasis verbunden sind und auf diesen bezogen werden können.

Die Zeit- und Frequenzsteuerung ZFS1 bzw. ZFS2 ist auch dafür verantwortlich, dass die Kohärenz zwischen den Signalen und Vektoren über die geforderte Länge erhalten bleibt, d.h. Einschwingvorgänge berücksichtigt und sich alle Funktionseinheiten auch in den Übergangsbereichen im linearen Regelbereichen befinden (u.a. Frequenzgenerator, PLL). Die Funkknoten FI und FT werden durch die Zeit- und Frequenzsteuerung ZFS1 bzw. ZFS2 während der Schrittfolge aus Schritt S1 und S2 gesteuert.

Die Schrittfolge schließt auch die Übergangsbereiche (Schrittverzögerung) ein, die als Verzögerungsglieder der Größe $T_{SV}$ dargestellt sind. Die Zeit- und Frequenzsteuerung ZFS1 bzw. ZFS2 übernimmt auch die Steuerung der Frequenz $\omega_p$ über einen verfügbaren Frequenzbereich.

Dadurch erzeugt die Zeit- und Frequenzsteuerung ZFS1 bzw. ZFS2 jeweils eine phasenkohärente Domain PD, in der die Hochfrequenzsynthese, die Erzeugung der entsprechenden Sendevektoren und die Extraktion der Empfangsvektoren zueinander phasenseitig in einer festen Beziehung stehen.

Weiterhin besitzt jeder Funkknoten jeweils eine Logikeinheit, die mittels einer Funktion F bzw. H auf Basis von Eingabeparametern (u.a. die empfangen Signalvektoren $R_I(m,n)$ und $R_T(m,n)$ und/oder über die Datenschnittstelle DS1 bzw. DS2 bereitgestellte Parameter) die Signalvektoren $V_T$ bzw. $V_I$ zur Erzeugung des entsprechenden Sendesignals $T_I(m,n)$ bzw. $T_T(m,n)$ bereitstellt.

Der maximale Index der Schrittfolge $n_{max}$ bestimmt sich aus der konkreten Auslegung des Messzyklus und wird im dargestellten Beispiel $n_{max}=6$ gewählt.

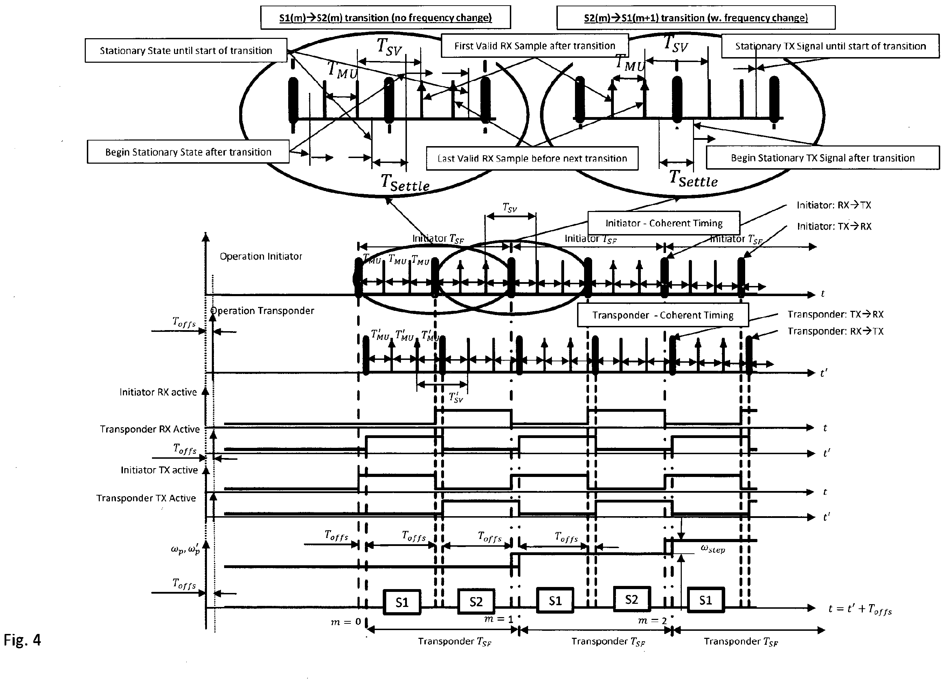

Wie in Figur 2 und 4 veranschaulicht ist, erzeugt der Frequenzgenerator im Initiator FI und im Transponder FT zunächst ein Signal der Frequenz $f_p$, fp' bzw. $\omega_p =2\pi \cdot f_p$, $\omega'_p =2\pi \cdot f'_p$, wobei das Signal des Frequenzgenerators des Transponders um den Zeitoffset $T_{offs}$ verzögert ist und einen statischen Phasenoffset $\Delta\varphi$ besitzt.

Im Sinne der weiteren Erläuterung werden die Frequenzen als gleich groß betrachtet. Es wird vorausgesetzt, dass entsprechende Frequenzoffsetkorrekturen (falls notwendig) bereits durchgeführt wurden bzw. die notwendigen Parameter extrahiert wurden um die Empfangsvektoren entsprechend zu korrigieren. Somit wird für die weiteren Aussagen $f_p=f_p'$ angenommen, wobei das Verfahren auch Frequenzunterschiede $f_p=f_p'+\Delta f$ einschließt, wenn $\Delta f$ bekannt, z.B. durch die Empfangsarchitektur vorgegeben, ist.

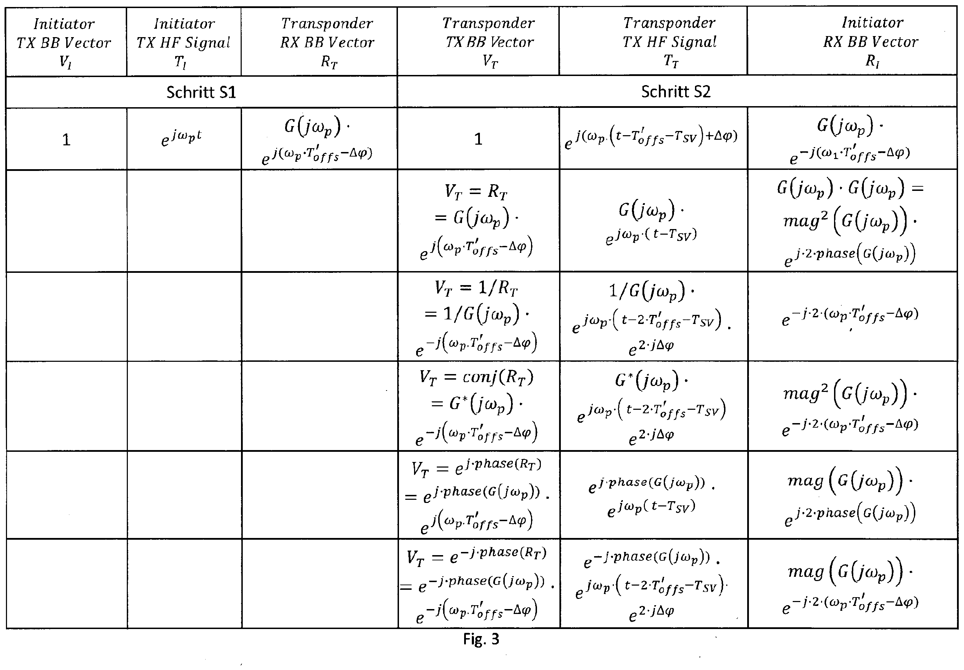

In einem ersten Schritt S1 m=0, n=0,1,2 wird von dem Initiator FI mittels eines Mischers und des Frequenzgenerators ein Initialsignal $T_I(m,n)$ mit einer ersten Trägerfrequenz $\omega_p$ mit dem Signalvektor $V_I(m,n)$ erzeugt und als Initialsignal $T_I(m,n)$ in das Ausbreitungsmedium PM ausgekoppelt. Zur Veranschaulichung und wie der in Figur 3 dargestellten Tabelle zu entnehmen ist, sei der Signalvektor $V_I(m,n)=1$, d.h. der Initiator-Funkknoten sendet ein Referenz-Signal mit einer Trägerfrequenz $\omega_p$ als Initialsignal $T_I$.

Es versteht sich, dass das Vorbeschriebene nicht ausschließt, dass die Signalvektor $V_{I,T}$ vor dem Auskoppeln in einem weiteren Mischer durch Multiplikation mit einem Hilfsträger, häufig als Local Oscillator bezeichnet, auf eine Zwischenfrequenz IF gebracht wird, bevor das Signal abschließend durch Umsetzung auf eigentlich Zielfrequenz $\omega_p$ umgesetzt wird.

Der Transponder FT bestimmt während eines ersten Empfangszeitraums S1 mit m=0, n=0,1,2 ein Empfangsvektor $R_T(m,n)$ durch Mischung des empfangenen HF-Signals mit dem Signal des Frequenzgenerators der Frequenz $f'_p$, das um Toffs gegenüber dem Generatorsignal des Initiators zeitlich verschoben ist.

Die Empfangsvektoren $R_T(n,m)$ haben die Form einer komplexen Zahl, wobei der Betrag proportional zum Betrag des empfangenen Signals ist.

In der Figur 2 wird die durch die Empfangseinheit des Transponders bestimmte Phase des Signalvektors $R_T(m,n)$ durch Abtastung des durch das Ausbreitungsmedium übertragene Sendesignals $T_I$ bezüglich des zeitkontinuierlichen Signals $\exp(j\omega'_p \cdot t')$ zu dem Zeitpunkten $t'=t'=n\cdot T'MU+m\cdot T'_{SF}$ erzeugt.

Das Empfangssignal $R_T(m,n)$ wird maßgeblich durch die Übertragungsfunktion des Funkkanals auf der Frequenz $f_p$ und den Zeit-und Phasenoffset $T_{offs}$ bzw. $\Delta\varphi$ zwischen den Zeitgebern bestimmt.

Im Sinne des Verfahrens ist $T_{MU}=T'_{Mu}$, $T_{SF}=T'_{SF}$, $T_z=T'_z$, usw. Anhand des Empfangssignals $R_T(m,n)$ wird ein Signalvektor $V_T(m,n+3)=F(R_T(m,n),...)$ gebildet und als Signalvektor $V_T$ an die Sendeeinheit TX des Transponders FT übermittelt.

Auch der Transponder bildet ein zeitdiskretes System mit $t'=n\cdot T'_{MU}+m\cdot T'_{ASF}$. In dem zweiten Schritt S2 m=0,n=3,4,5 wird von dem Transponder FT aus dem ermittelten Basisbandvektor $V_T(m,n)$ mittels eines Mischers und dem Frequenzgenerator ein Sende Signal $T_T(m,n)$ mit der Frequenz $f'_p$ erzeugt und als Antwortsignal $T_T$ in das Ausbreitungsmedium PM ausgekoppelt.

Das Antwortsignal $T_T$ m=0,n=3,4,5 wird dabei aus dem Empfangsvektor $R_T(m,n)$ m=0,n=0,1,2 mit Hilfe der Funktion $F(R_T(m,n),...)$ und somit zumindest aus einem Teil des Empfangsvektors $R_T$ gebildet. Einige Möglichkeiten der Bildung des Antwortsignals $T_T$ sind den Zeilen 2 bis 6 der Tabelle der Figur 3 zu entnehmen.

Der Initiator FI bestimmt während eines zweiten Empfangszeitraums m=0,n=3,4,5 den Empfangsvektor $R_I(m,n),...)$ mit m=0,n=3,4,5.

Die Empfangsvektoren $R_I(n,m)$ haben die Form einer komplexen Zahl, wobei der Betrag proportional zum Betrag des empfangenen Signals ist.

Analog ergibt sich die durch die Empfangseinheit des Initiator bestimmte Phase des Signalvektor RT(m,n) durch Abtastung des durch das Ausbreitungsmedium übertragene Sendesignals TT bezüglich des zeitkontinuierlichen Signals $\exp(j\omega_p \cdot t)$ zu dem Zeitpunkt $t=t=n\cdot T_{MU}+m\cdot T_{SF}$.

Das empfangene HF Signal der Frequenz $f'_p$ wird mit einem Mischer und dem Signal des Frequenzgenerators der Frequenz $f_p$ in die Basisbandlage konvertiert. Die entsprechenden Empfangsvektoren $R_I$ sind ebenfalls in der Tabelle der Figur 3 angegeben.

Die entsprechenden zeitdiskreten Werte ergeben sich für den Initiator aus $t=n\cdot T_{Mu}+m\cdot T_{SF}$ und den Transponder aus $t'=n\cdot T'_{MU}+m\cdot T'_{SF}$.

Mit Bezug auf Figur 2 bilden die Sende- und Empfangseinheit des Transponder zusammen mit dem Zeitgeber und der Ablaufsteuerung eine phasenkohärente Domäne PD, die dadurch gekennzeichnet ist, dass die Phase der Sendesignals $T_T=V_T(m,n)\cdot\exp(j\omega'p\cdot t')$ als $T_T(S2,m,n)$ zu den Zeitpunkten $t'=n\cdot T'_{MU}+m\cdot T'_{SF}$ (S2: n={4,5}) phasenkohärent zur Referenzphase des zeitkontinuierlichen Signals $\exp(j\omega'_p \cdot t')$ für die Ermittlung der Phase des Empfangsvektors $R_T$ zu den Zeitpunkten $t'=n\cdot T'_{MU}+m\cdot T'_{SF}$ (S1:n={1,2}) ist.

Mit Bezug auf Figur 2 bilden die Sendeeinheit und die Empfangseinheit des Initiators zusammen mit dem Zeitgeber und der Ablaufsteuerung eine phasenkohärente Domäne PD, die dadurch gekennzeichnet ist, dass die Phase der Sendesignals $T_I=VI(m,n)\cdot\exp(j\omega_p \cdot t)$ als $T_I(S1,m,n)$ zu den Zeitpunkten $t=n\cdot T_{Mu}+m\cdot T_{SF}$ (S1: n={1,2}) phasenkohärent zur Referenzphase des zeitkontinuierlichen Signals $\exp(j\omega_p \cdot t)$ für die Ermittlung der Phase des Empfangsvektors $P_T$ zu den Zeitpunkten $t'=n \cdot T_{MU}+m \cdot T_{SF}$ (S2:n={4,5}) ist.

Aus den Anforderungen bzgl. Phasenkohärenz der jeweiligen Funkknoten ergibt sich eine Phasenkohärenz der Funkknoten zueinander, wenn die sich die Zeitgeber nur in einem Zeitversatz unterscheiden und ansonsten beide Knoten dem gleichen zeitlichen Ablauf auf Basis $T_{MU}$, bzw. $T_{Mu}$ folgen, der Empfangs-und Sendeverhalten zueinander komplementär ist.

Wie der Tabelle der Figur 3 zu entnehmen, ist es durch das Übermitteln von Informationen über das empfangene Initialsignal $T_I$ mittels des Antwortsignals $T_T$ möglich, direkt anhand der empfangenen Antwortsignale $T_T$ eine Transferfunktion für den Umlauf (Schrittfolge aus Schritt S1 und Schritt S2) und/oder einen Zeitversatz zu ermitteln. In der Tabelle der Figur 3 ist eine Auswahl möglicher Empfangsvektoren und Antwortsignalvektoren aufgelistet.

Eine Schrittfolge aus dem ersten Schritt S1 und dem zweiten Schritt S2 wird mehrfach wiederholt, wobei bei jeder Wiederholung, die Trägerfrequenzen $\omega_p$ und $\omega'_p$ innerhalb eines vorbestimmten Frequenzbereichs nach den entsprechenden Anforderungen ausgewählt werden. Im dargestellten Ausführungsbeispiel entspricht die zweite Trägerfrequenz $\omega'_p$ der ersten Trägerfrequenz $\omega_p$.

Die Wiederholungen einer Schrittfolge bilden einen Messzyklus, wobei m mit jeder abgeschlossenen Schrittfolge inkrementiert und $\omega_p$ entsprechende den Anforderungen ausgewählt wird. Im Falle eines Frequenz-Sweeps wird $\omega_p$ mit jedem Messzyklus um $\omega_{step}$ erhöht.

Um eine Kohärenz jedes Initialsignals $T_I$ und des folgenden Antwortsignals $T_T$ während einer Schrittfolge oder eine Kohärenz der Initialsignale $T_I$ und der Antwortsignale $T_T$ über mindestens eines Messzyklus (im Falle der komplexeren Ableitungen ist Kohärenz über einen ganzen Messzyklus auszudehnen) zu gewährleisten, verfügen der Initiator FI sowie der Transponder FT jeweils über eine kohärente Zeit- und Frequenzkontrolle, wobei eine grobe Zeitsynchronisation, beispielsweise durch den Austausch von Datenframes über die Datenschnittstellen DS1 und DS2, erfolgt.

Der zeitliche Ablauf des Verfahrens ist in der Figur 4 skizziert. Über den Zeitachsen t bzw. $t'=t+T_{offs}$ sind der Verlauf der Frequenzen $\omega_p$ bzw. $\omega'_\rho$, eine Aktivität der Sendeeinheiten TX des Transponders FT und des Initiators FI, eine Aktivität der Empfangseinheiten RX des Transponders FT sowie des Initiators FI über drei Schrittfolgen m=0 bis m=2 dargestellt, wobei eine Schrittfolge eine Zeitspanne $T_{SF}$ einnimmt. Darüber sind die Aktivitäten des Transponders FT und des Initiators FI als senkrechte verlaufende Balken dargestellt, wobei fette Balken jeweils das Umschalten von Empfang auf Senden bzw. von Senden auf Empfang, dünne Balken jeweils das Senden eines Signals und Pfeile das Empfangen eines Signals kennzeichnen.

Die Messzeiteinheiten, also die zeitlichen Abstände zwischen den verschiedenen Aktivitäten, werden als $T_{MU}$ bzw. $T_{MU}$ bezeichnet. Zwischen der ersten Sendeaktivität und der ersten Empfangsaktivität bzw. vice versa liegt immer eine Schrittverzögerung $T_{SV}$. Hierdurch werden Einflüsse bzw. Störungen durch einen Einschwingvorgang der Funkknoten vermieden. Die Schrittverzögerung $T_{SV}$ ist entsprechend größer als eine Einschwingzeit $T_{settle}$. Gleichzeitig ist zu vermerken, dass die vorgestellten Beziehungen einen eingeschwungenen stationären Zustand voraussetzen. Diese Bedingung ist nur für Bereiche der Schrittfolge erfüllt, die durch Übergangsbereiche abgegrenzt sind, in denen die entsprechenden Einschwingvorgänge stattfinden. In diesen sind die entsprechenden Signalvektoren nur eingeschränkt im Sinne des Verfahrens verwendbar. Für den dargestellten Fall betrifft dies die Vektoren $R_{I,T}(m,n)$ mit n=0,3.

Für die Umsetzung des Verfahrens im bisher dargestellten Sinne wird mindestens ein gültiger Empfangsvektor pro Funkknoten pro Schritt innerhalb der Schrittfolge benötigt.

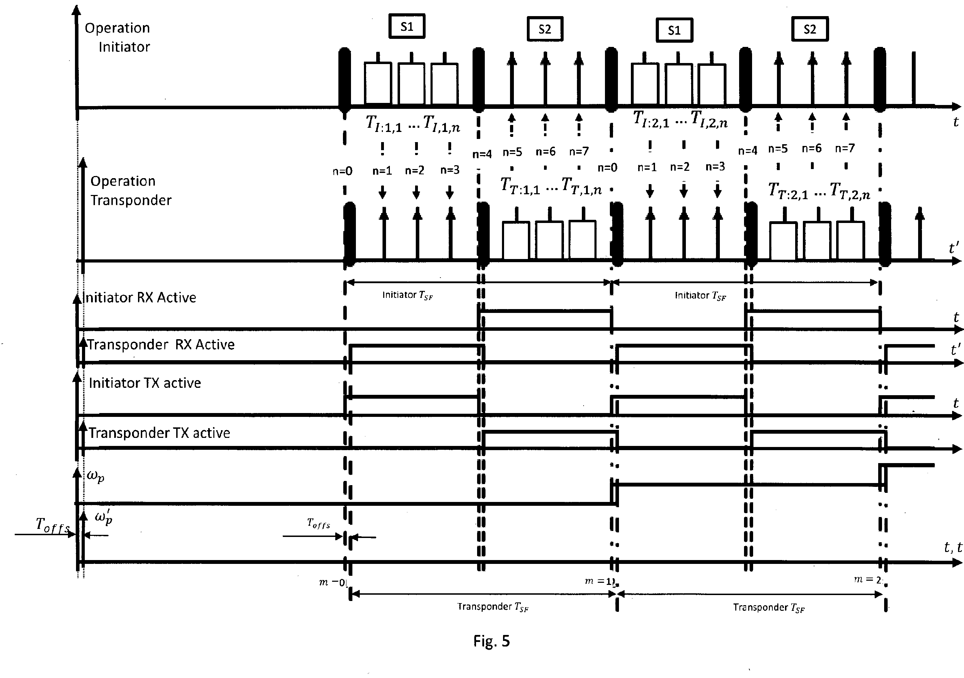

Die Abbildung der Figur 5 veranschaulicht ein Ablaufschema eine weitere alternative Ausführungsform des erfindungsgemäßen Verfahrens für Funkmessanwendungen, wobei im Folgenden nur die Unterschiede gegenüber den vorangegangenen Figuren erläutert werden.

Die Ausführungsform beruht auf einer Erweiterung der Schrittfolge in Sende- und Empfangszeiträume mit mehreren separaten Sende- bzw. Empfangszeitfenstern, wobei eine solche Konfiguration mit $n_{max}=8$ dargestellt ist.

Geht man von einer symmetrischen Verteilung zwischen dem Initiator FI und dem Transponder FT aus, so stehen die entsprechenden zeitkontinuierliche Sende-Signale $T_{I,T}$ mit ihren Werten zu den Zeitpunkten $t=n \cdot T_{MU}+m \cdot T'_{SF}$ und $t'=n \cdot T'_{MU}+m \cdot T'_{SF}$ ($T_I(m,n=0:1/2 \cdot n_{max}-1)$ und $T_T(m,n=1/2 \cdot n_{max}:n_{max}-1)$) auf der anderen Seite die entsprechende Anzahl an Empfangszeitfenster gegenüber und erlauben damit die Ermittlung der zugehörigen Empfangsvektoren $P_T(m,n=0:1/2 \cdot n_{max}-1)$ und $R_I(m,n=1/2 \cdot n_{max}: n_{max}-1)$.

Die somit zur Verfügung stehenden Zeitfenster bieten sich für verschiedene Zwecke an. Eine Auswahl sei hier zusammengestellt:

- Übertragung der Referenzphase des Transponders
- Signalisierung zwischen Initiator und Transponder (Verstärkungs- und Sendeleistungsanpassungen,..., Verschlüsselung)
- Rauschunterdrückung durch Mittelwertbildung von mehreren Empfangsvektoren die auf Basis eines Sendevektors der Gegenseite erzeugt wurden
- Zuordnung zu verschiedenen Antennen zur Erzeugung von Raumdiversität zur Ermittlung von Einfallswinkeln im speziellen und zur Verbesserung der Messgenauigkeit im Allgemeinen (Beam Steering, MIMO, Smart Antenna),
- Zur Detektion von Kanalbelegungen im Sinne von LBT (Listen-before-Talk), CS (Carrier Sense) und DAA (Detect and Avoid) Anforderungen für die Zulassung von Funksystemen.

Bei der Dimensionierung sind sowohl die jeweiligen Einschwingvorgänge als auch die Grenzen der durch die Grobsynchronisation erreichbaren maximalen Zeitoffsetschwankungen zu beachten und entsprechende die Schrittverzögerungs- bzw. Guard-Intervalle $T_{SV}$ auszulegen.

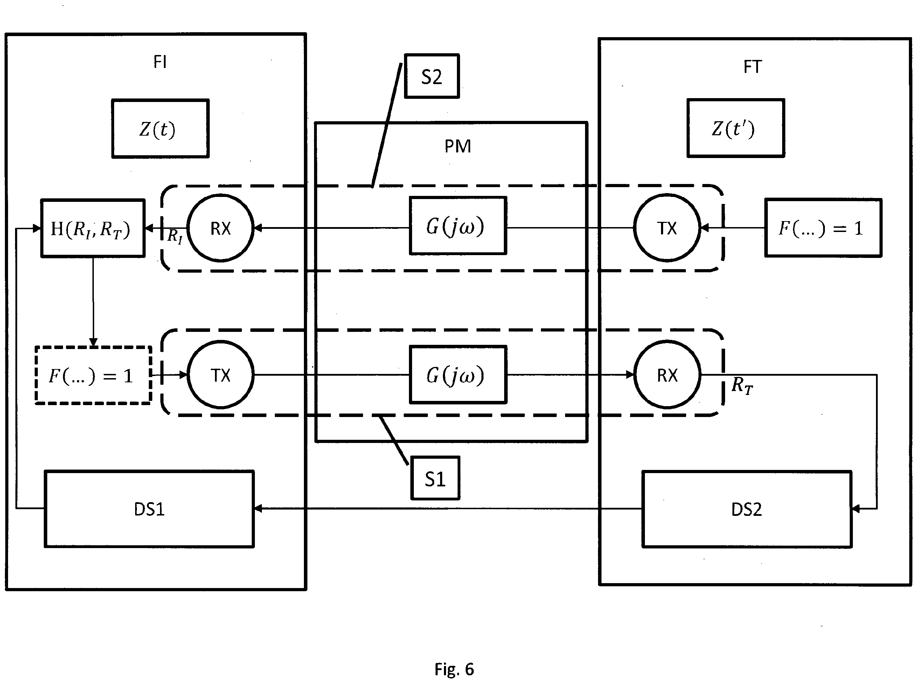

In der Figur 6 ist das erfindungsgemäße Verfahren gemäß einer ersten Ausführungsform des Modus 2 dargestellt. Im Folgenden werden die Unterschiede zu den vorangegangenen Figuren erläutert.

Die Figur 6 zeigt eine Anordnung des Initiators FI und des Transponders FT im Modus 2.

Der erste Schritt S1 wird zunächst in gleicher Form wie bei Modus 1 ausgeführt. Im Rahmen des zweiten Schritts S2 ist der Transponder FT dazu ausgelegt, mittels der Sendeeinheit TX das Antwortsignal $T_T$ zu erzeugen, wobei der Basisbandvektor $V_T$ zu $V_T(m,n)=1$ für die Erzeugung des Antwortsignals $T_T$ gewählt wird.

Das bedeutet, dass der Transponder ein Signal $T_T$ sendet, das nur von seiner eigenen Zeitreferenz abhängig ist und damit unabhängig vom empfangenen Initiator Sendesignal $T_I$ bzw. dem daraus ermittelten Empfangssignalvektor $R_T$ ist. Diese Ausführungsform entspricht der ersten Zeile der Tabelle der Figur 3.

Der Transponder FT ist zusätzlich dazu ausgelegt, den im ersten Schritt S1 ermittelten Empfangsvektor $R_T$ mittels der Datenschnittstelle DS2 an den Initiator zu übermitteln.

Der Initiator FI ist zusätzlich dazu ausgelegt, die Empfangsvektoren $R_T$ mittels der Datenschnittstelle DS1 zu erhalten und anhand zumindest eines Teils der erhaltenen Empfangsvektoren $R_T$ und der ermittelten Messvektoren $R_I$ den Zeitversatz $T_{offs}$ zu bestimmen.

Anhand des Zeitversatzes $T_{offs}$ und zumindest eines Teils der von dem Initiator FI empfangenen Empfangsvektoren $R_I$ kann dann eine Transferfunktion für den Funkkanal zwischen dem Transponder FT und dem Initiator FI ermittelt werden. Es ist somit möglich direkt die Transferfunktion für einen einfachen Weg zwischen Initiator und Transponder und nicht für einen zwei Wege umfassenden Umlauf zu bestimmen.

Nachfolgend wird auf die wesentlichen Eigenschaften der einfachen Kanalübertragungsfunktion $G_{1WR}(j\omega)=G(j\omega)$ gegenüber der weit verbreiteten Ermittlung der Umlaufkanalübertragungsfunktion $G_{2WR}(j\omega)=G^2(j\omega)$ eingegangen.

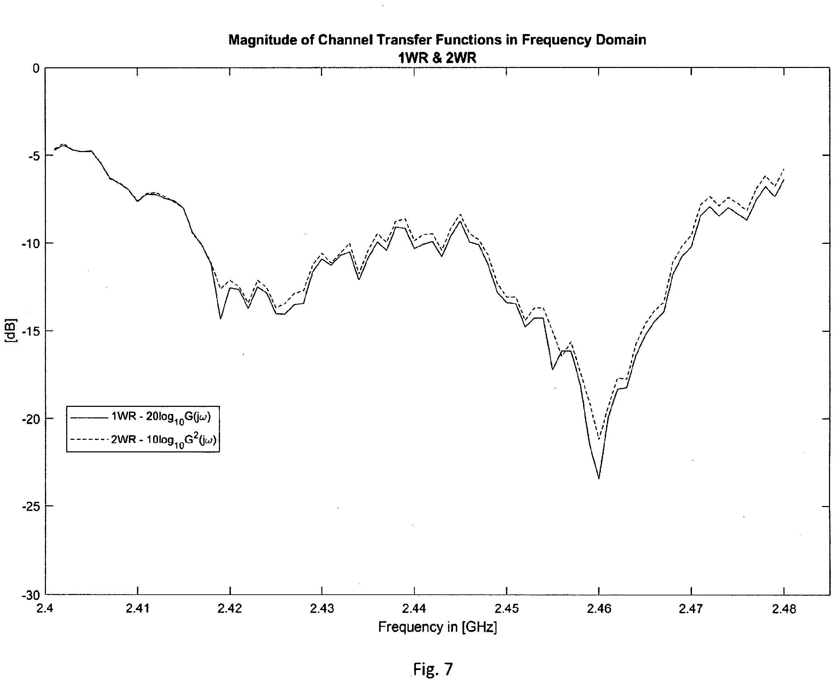

In der Abbildung der Figur 7 ist beispielhaft in einer typischen Mehrwegeumgebung der Amplitudenverlauf im Frequenzbereich von beiden Funktionen auf Basis von Messwerten dargestellt. Da die Umlaufkanalübertragungsfunktion dem Quadrat der Einwegkanalübertragungsfunktion entspricht, ist die Umlaufkanalübertragungsfunktion mit 10log10 skaliert und die Einwegkanalübertragungsfunktion mit 20log10. Die entsprechenden Verläufe sind annähernd gleich.

Die Bedeutung der Extraktion der Einwegkanaltransferfunktion erschließt sich mit Hilfe der Fourier-Transformation in den Zeitbereich; die entsprechenden Kanalimpulsantworten geben Aufschluss über das Mehrwegverhalten.

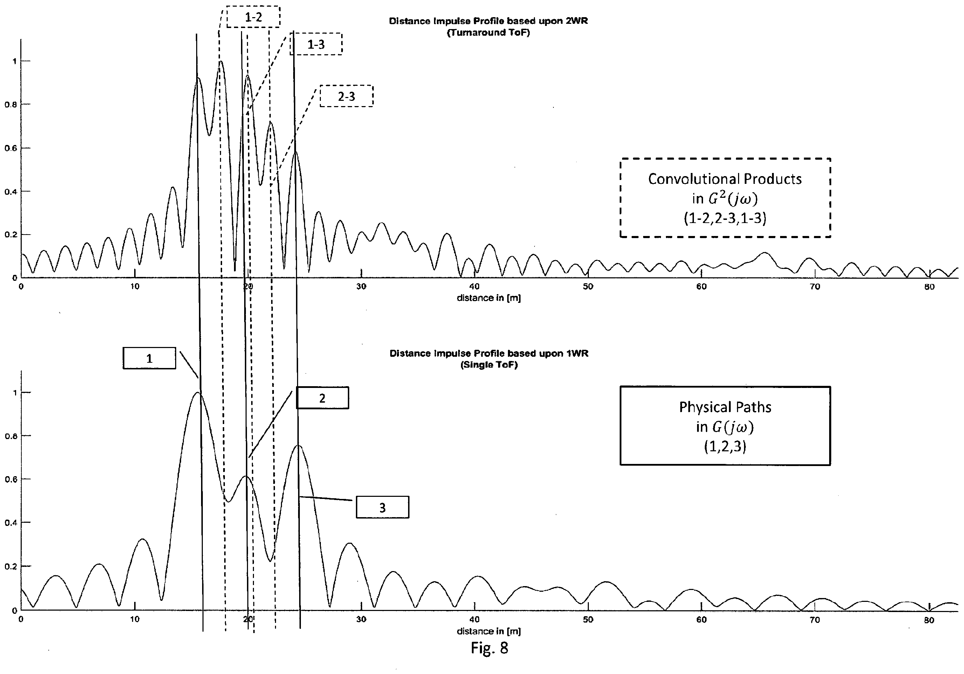

Die entsprechenden Impulsantworten sind in der Figur 8 dargestellt. In dem oberen Diagramm ist die ermittelte Transferfunktion für einen einzigen Weg zwischen Initiator und Transponder und in dem unteren Diagramm die gemäß dem ersten Modus ermittelte Transferfunktion für den Umlauf dargestellt. Es ist deutlich zu erkennen, dass das Messergebnis für einen Umlauf stärker von weiteren Pfaden dominiert ist, während das Messergebnis der Einwegekanaltransferfunktion von der Energie des direkten Pfades 1 dominiert wird und weitere Wege 2 und 3 abbildet.

Die Ursache liegt im 2-fachen Durchlauf der elektromagnetischen Wellen durch das entsprechende Ausbreitungsmedium. Die resultierende Transferfunktion entspricht im Zeitbereich der Faltung der 1WR Kanalimpulsantwort mit sich selbst. Die 2WR-Kanalimpulsantwort enthält damit neben den Pfaden der 1WR-Kanalimpulsantwort (1,2,3) zusätzliche Pfade (1-2,1-3, 2-3) die aus der Faltung der Pfade untereinander entstehen.

Wie aus der Darstellung deutlich wird, können diese Faltungsprodukte auch die Ausprägung der Pfade 1,2,3 innerhalb der 2WR Darstellung beeinflussen, da sich diesen überlagen. Dies wird deutlich am Pfad 2 innerhalb der 2WR Darstellung. Gleichzeitig wird deutlich, dass die Faltungsprodukte durchaus auch die direkten Pfade dominieren können. So ist in der 1WR Darstellung der Pfad 1 der Dominierende. Das 2WR Ergebnis wird dagegen durch die Energie des Faltungsprodukts 1-2 dominiert.

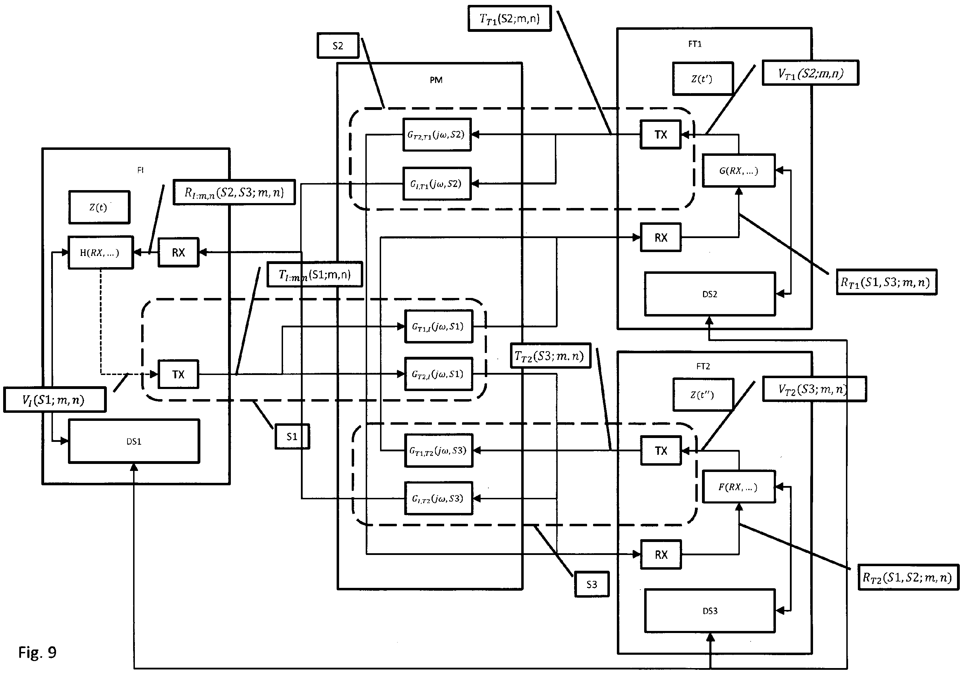

Die Abbildung der Figur 9 zeigt schematische eine Anordnung von drei Funkknoten FI, FT1 und FT2 zur Durchführung einer weiteren alternativen Ausführungsform des erfindungsgemäßen Verfahrens für Funkmessanwendungen. Jeder der drei Funkknoten FI, FT1 und FT2 verfügt jeweils über eine Empfangseinheit RX, eine Sendeeinheit TX, eine Datenschnittstelle DS1 bzw. DS2 bzw. DS3 und einen eigenen Zeitgeber Z(t) bzw. Z(t') bzw. Z(t").

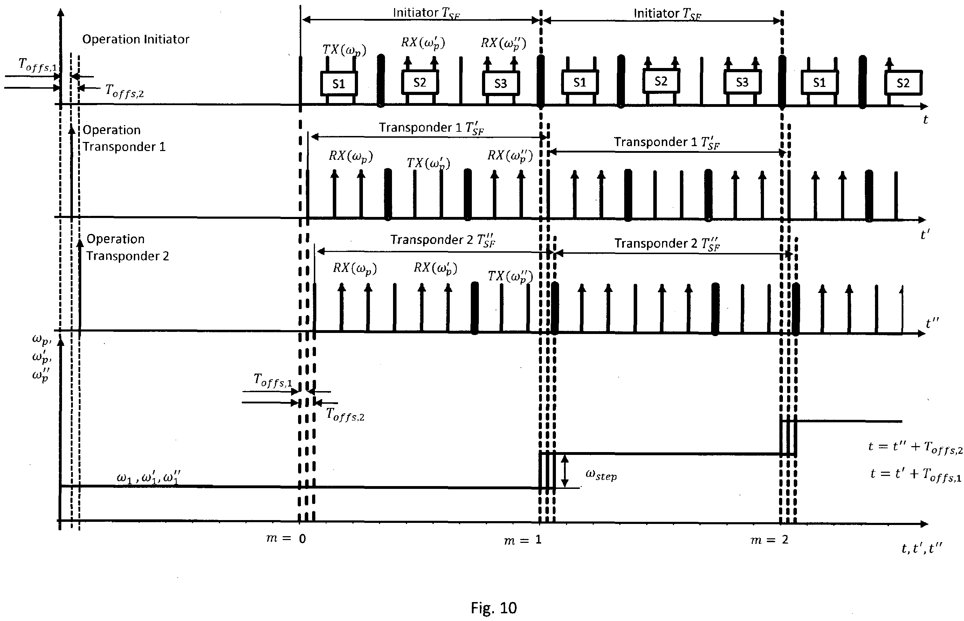

Die Abbildung der Figur 10 veranschaulicht einen Ablauf des erfindungsgemäßen Verfahrens mit drei Funkknoten über die jeweilige Zeitachse t bzw. t' bzw. t". Zwischen den einzelnen Zeitbasen besteht jeweils ein Zeitoffset $T_{offs,1}$ bzw. $T_{offs,2}$. Ein erster Funkknoten FI bildet den Initiator und die beiden weiteren Funkknoten FT1 und FT2 bilden jeweils einen Transponder. Im Folgenden werden nur die Unterschiede zu den vorangegangenen Abbildungen, insbesondere zu Figur 4, erläutert.

Eine Schrittfolge besteht aus drei Schritten, wobei in dem ersten Schritt S1, der Initiator FI in dem Sendemodus ein Initialsignal $T_I$ aussendet, welches von den beiden Transpondern FT1 und FT2 empfangen wird, in dem zweiten Schritt S2 der erste Transponder FT1 ein Antwortsignal $T_{T1}$ aussendet, welches von dem Initiator FI und dem zweiten Transponder FT2 empfangen wird, und in dem dritten Schritt S3, der zweite Transponder FT2 ein Antwortsignal $T_{T2}$ aussendet, welches von dem Initiator FI und dem ersten Transponder FT1 empfangen wird.

Die Schrittfolge nimmt ein Zeitintervall $T_{SF}$ ein und wird mehrfach wiederholt, wobei der Index m die Wiederholungen angibt. Das Initialsignal $T_I$ sowie beide Antwortsignale $T_{T1}$ und $T_{T2}$ zumindest während einer Schrittfolge, also während des Zeitintervalls $T_{sf}$ kohärent sind.

Der dritte Schritt S3 entspricht somit einer Wiederholung des zweiten Schritts S2, nur dass ein anderer Transponder das Antwortsignal sendet.

**Patentansprüche**

1. Verfahren für Funkmessanwendungen, wobei

   - wenigstens zwei Funkknoten bereitgestellt werden,
   - mindestens ein erste Funkknoten als Initiator und mindestens ein zweiter Funkknoten als Transponder arbeitet,
   - der erste Funkknoten und der zweite Funkknoten jeweils einen eigenen Zeitgeber, einen Signalprozessor, wenigstens eine Antenne und eine Datenschnittstelle aufweisen,
   - zwischen den Zeitgebern des ersten Funkknotens und des zweiten Funkknotens ein Zeitversatz besteht,
   - in einem ersten Schritt von dem Initiator mit einer ersten Trägerfrequenz ein Initialsignal gesendet wird und von dem Transponder während eines ersten Empfangszeitraums das Initialsignal empfangen wird,
   - in einem zweiten Schritt von dem Transponder mit einer zweiten Trägerfrequenz ein Antwortsignal gesendet wird und von dem Initiator während eines zweiten Empfangszeitraums das Antwortsignal empfangen wird,
   - eine Schrittfolge aus dem ersten Schritt und dem zweiten Schritt in der genannten Reihenfolge wenigstens einmal wiederholt wird,
   - das Initialsignal und das Antwortsignal zumindest während jeder Schrittfolge kohärent sind, und
   - die Trägerfrequenz des Initialsignals und die Trägerfrequenz des Antwortsignals bei jeder Wiederholung innerhalb eines vorbestimmten Frequenzbereichs geändert werden,

   **dadurch gekennzeichnet, dass**

   - das Verfahren entweder in einem ersten Modus oder in einem zweiten Modus arbeitet, wobei
   - in dem ersten Modus von dem Transponder das Antwortsignal zumindest aus einem Teil des empfangenen Initialsignals gebildet und eine Transferfunktion und/oder der Zeitversatz anhand zumindest eines Teils der empfangenen Antwortsignale ermittelt wird, wobei
   - in dem ersten Modus von dem Transponder entweder aus dem Initialsignal ein erster komplexer Signalvektor ermittelt und das Antwortsignal aus dem ersten komplexen Signalvektor oder aus dem reziproken ersten komplexen Signalvektor oder aus dem konjugiert komplexen ersten Signalvektor gebildet wird,
   - oder von dem Transponder aus dem Initialsignal eine erste Phase ermittelt und das Antwortsignal aus der ersten Phase oder der invertierten ersten Phase gebildet wird und
   - in dem zweiten Modus das Antwortsignal unabhängig von dem empfangenen Initialsignal gebildet wird, mindestens zwei empfangene Initialsignale mittels der Datenschnittstelle übermittelt werden und mindestens eine Transferfunktion und/oder der Zeitversätze anhand zumindest eines Teils der empfangenen Antwortsignale und zumindest eines Teils der empfangenen und übermittelten Initialsignale ermittelt wird.

2. Verfahren nach Anspruch 1, **dadurch gekennzeichnet, dass** die zweite Trägerfrequenz der ersten Trägerfrequenz entspricht oder sich von der ersten Trägerfrequenz unterscheidet.

3. Verfahren nach Anspruch 1 oder 2, **dadurch gekennzeichnet, dass** ein Messzyklus aus mehreren Wiederholungen der Schrittfolge gebildet wird und das Initialsignal und das Antwortsignal mindestens während eines Messzyklus oder mindestens während mehrere Messzyklen kohärent sind.

4. Verfahren nach einem der vorangegangenen Ansprüche, **dadurch gekennzeichnet, dass** immer mindestens ein Funkknoten als Initiator und immer mindestens ein Funkknoten als Transponder arbeitet, wobei jeder Funkknoten über mehrere Schrittfolgen mindestens einmal als Initiator und mindestens einmal als Transponder arbeitet oder jeder Funkknoten über mehrere Schrittfolgen nur als Initiator oder nur als Transponder arbeitet.

5. Verfahren nach einem der vorangegangenen Ansprüche, **dadurch gekennzeichnet, dass** ein Messzyklus aus mehreren Wiederholungen der Schrittfolge gebildet wird und die erste Trägerfrequenz für jede Wiederholung während des Messzyklus jeweils einen vorbestimmten Wert innerhalb des Frequenzbereichs annimmt.

6. Verfahren nach einem der vorangegangenen Ansprüche, **dadurch gekennzeichnet, dass** anhand der ermittelten Transferfunktion und/oder des Zeitversatzes ein Abstand zwischen dem mindestens einen Initiator und dem mindestens einen Transponder bestimmt wird.

7. Verfahren nach einem der vorangegangenen Ansprüche, **dadurch gekennzeichnet, dass** für mindestens eine ermittelte Transferfunktion eine Mehrwege-Analyse durchgeführt wird.

8. Verfahren nach einem der vorangegangenen Ansprüche, **dadurch gekennzeichnet, dass** auf die empfangenen Antwortsignale und/oder die empfangenen Initialsignale ein Filter angewandt wird.

9. Verfahren nach einem der vorangegangenen Ansprüche, **dadurch gekennzeichnet, dass** bei jeder Wiederholung zusätzlich zu der Trägerfrequenz des Initialsignals eine Amplitude und/oder eine Phase des Initialsignals verändert wird.

10. Verfahren nach einem der vorangegangenen Ansprüche, **dadurch gekennzeichnet, dass** mindestens drei Funkknoten bereitgestellt werden und in jeder Schrittfolge der zweite Schritt mindestens einmal wiederholt wird, wobei in dem ersten Schritt das Initialsignal von mindestens zwei als Transponder fungierenden Funkkoten empfangen wird, in jedem zweiten Schritt von genau einem der Transponder das Antwortsignal gesendet und von dem Initiator sowie von mindestens einem weiteren Transponder empfangen wird, bei jeder Wiederholung des zweiten Schritts ein anderer Transponder das Antwortsignal sendet und in dem ersten Modus bei jeder Wiederholung des zweiten Schritts das Antwortsignal jeweils zumindest aus einem Teil des empfangenen Initialsignals oder aus einem Teil des empfangenen Antwortsignals gebildet wird.

11. Verfahren nach einem der vorangegangenen Ansprüche, **dadurch gekennzeichnet, dass** der Initiator das Initialsignal während eines ersten Sendezeitraums sendet und der Transponder das Antwortsignal während eines zweiten Sendezeitraums sendet, wobei der erste Sendezeitraum und der zweite Sendezeitraum jeweils mehrere, aufeinanderfolgende Zeitfenster umfassen, jeweils nur während der Zeitfenster gesendet wird und jeweils zwei aufeinanderfolgende Zeitfenster zeitlich unmittelbar aufeinander folgen oder zeitlich einen Abstand zueinander aufweisen.

## Claims

1. Method for radio measuring applications, wherein

- at least two radio nodes are provided,
- at least one first radio node operates as an initiator and at least one second radio node operates as a transponder,
- the first radio node and the second radio node each comprise an individual time transmitter, a signal processor, at least one antenna and a data interface,
- a time offset is present between the time transmitters of the first radio node and the second radio node,
- in a first step an initial signal is transmitted by the initiator at a first carrier frequency and the initial signal is received by the transponder during a first receiving time period,
- in a second step a response signal is transmitted by the transponder at a second carrier frequency and the response signal is received by the initiator during a second receiving time period,
- a step sequence of the first step and the second step is repeated at least once in the said sequence,
- the initial signal and the response signal are coherent at least during each step sequence and
- the carrier frequency of the initial signal and the carrier frequency of the response signal are changed within a predetermined frequency range with each repetition, **characterised in that**
- the method operates either in a first mode or in a second mode, wherein
- in the first mode the response signal is formed by the transponder at least from a part of the received initial signal and a transfer function and/or the time offset is or are determined on the basis of at least a part of the received response signals, wherein
- in the first mode either a first complex signal vector is determined by the transponder from the initial signal and the response signal is formed from the first complex signal vector or from the reciprocal first complex signal vector or from the conjugated complex first signal vector,
- or a first phase is determined by the transponder from the initial signal and the response signal is formed from the first phase or the inverted first phase and
- in the second mode the response signal is formed in dependence on the received initial signal, at least two received initial signals are communicated by means of the data interface and at least one transfer function and/or the time offsets is or are determined on the basis of at least a part of the received response signals and at least a part of the received and communicated initial signals.

2. Method according to claim 1, **characterised in that** the second carrier frequency corresponds with the first carrier frequency or differs from the first carrier frequency.

3. Method according to claim 1 or 2, **characterised in that** a measuring cycle is formed from a plurality of repetitions of the step sequence and the initial signal and the response signal are coherent at least during one measuring cycle or at least during a plurality of measuring cycles.

4. Method according to any one of the preceding claims, **characterised in that** at least one radio node always operates as initiator and at least one radio node always operates as transponder, wherein each radio node over several step sequences operates at least once as initiator and at least once as transponder or each radio node over several step sequences operates only as initiator or only as transponder.

5. Method according to any one of the preceding claims, **characterised in that** a measuring cycle is formed from a plurality of repetitions of the step sequence and the first carrier frequency for each repetition during the measuring cycle respectively adopts a predetermined value within the frequency range.

6. Method according to any one of the preceding claims, **characterised in that** a spacing between the at least one initiator and the at least one transponder is determined on the basis of the determined transfer function and/or the time offset.

7. Method according to any one of the preceding claims, **characterised in that** a multipath analysis is carried out for at least one determined transfer function.

8. Method according to any one of the preceding claims, **characterised in that** a filter is used on the received response signals and/or the received initial signals.

9. Method according to any one of the preceding claims, **characterised in that** for each repetition in addition to the carrier frequency of the initial signal an amplitude and/or a phase of initial signal is or are changed.

10. Method according to any one of the preceding claims, **characterised in that** at least radio nodes are provided and in each step sequence the second step is repeated at least once, wherein in the first step the initial signal is received by at least two radio nodes functioning as transponder, in each second step the response signal is transmitted by exactly one of the transponders and is received by the initiator as well as by at least one further transponder, in each repetition of the second step another transponder transmits the response signal and in the first mode with each repetition of the second step the response signal is formed each time at least from a part of the received initial signal or from a part of the received response signal.

11. Method according to any one of the preceding claims, **characterised in that** the initiator transmits the initial signal during a first transmission time period and the transponder transmits the response signal during a second transmission time period, wherein in the first transmission time period and the second transmission time period each comprise a plurality of successive time windows, on each occasion there is transmission only during the time window and on each occasion two successive time windows directly follow one another in time or have a mutual spacing in time.

## Revendications

1. Procédé pour des applications de mesure radio, dans lequel

- au moins deux nœuds radio sont prévus,
- au moins un premier nœud radio fonctionne en tant qu'initiateur et au moins un second nœud radio fonctionne en tant que transpondeur,
- le premier nœud radio et le second nœud radio comprennent respectivement leur propre temporisateur, un dispositif de traitement de signal, au moins une antenne ainsi qu'une interface de données,
- il existe un décalage temporel entre le temporisateur du premier nœud radio et le temporisateur du second nœud radio,
- dans une première étape, un signal initial est émis par l'initiateur à une première fréquence porteuse et le signal initial est reçu par le transpondeur au cours d'une première période de réception,
- dans une seconde étape, un signal de réponse est émis par le transpondeur à une seconde fréquence porteuse et le signal de réponse est reçu par l'initiateur au cours d'une seconde période de réception,
- une séquence d'étapes de la première étape et de la seconde étape est répétée au moins une fois dans l'ordre indiqué,

- le signal initial et le signal de réponse sont cohérents au moins au cours de chaque séquence d'étapes, et
- la fréquence porteuse du signal initial et la fréquence porteuse du signal de réponse sont modifiées lors de chaque répétition à l'intérieur d'une plage de fréquences prédéterminée,

**caractérisé en ce que**

- le procédé fonctionne soit dans un premier mode, soit dans un second mode, dans lequel
- dans le premier mode, le signal de réponse est formé par le transpondeur au moins à partir d'une partie du signal initial reçu et une fonction de transfert et/ou le décalage temporel est (sont) déterminé(s) sur la base d'au moins une partie des signaux de réponse reçus, dans lequel
- dans le premier mode, soit un premier vecteur de signal complexe est déterminé par le transpondeur à partir du signal initial et le signal de réponse est formé à partir du premier vecteur de signal complexe soit à partir du premier vecteur de signal complexe réciproque, soit à partir du premier vecteur de signal complexe conjugué,
- soit une première phase est déterminée par le transpondeur à partir du signal initial et le signal de réponse est formé à partir de la première phase ou de la première phase inversée, et
- dans le second mode, le signal de réponse est formé indépendamment du signal initial reçu, au moins deux signaux initiaux reçus sont transmis par l'intermédiaire de l'interface de données et au moins une fonction de transfert et/ou le décalage temporel est (sont) déterminé(s) sur la base d'au moins une partie des signaux de réponse reçus et d'au moins une partie des signaux initiaux reçus et transmis.

2. Procédé selon la revendication 1, **caractérisé en ce que** la seconde fréquence porteuse correspond à la première fréquence porteuse ou est différente de la première séquence porteuse.

3. Procédé selon la revendication 1 ou 2, **caractérisé en ce qu'**un cycle de mesure est formé à partir d'une pluralité de répétitions de la séquence d'étapes et le signal initial et le signal de réponse sont cohérents au moins au cours d'un cycle de mesure ou au moins au cours de plusieurs cycles de mesure.

4. Procédé selon l'une quelconque des revendications précédentes, **caractérisé en ce qu'**au moins un noeud radio fonctionne toujours en tant qu'initiateur et au moins un nœud radio fonctionne toujours en tant que transpondeur, dans lequel chaque nœud radio fonctionne au moins une fois en tant qu'initiateur et au moins une fois en tant que transpondeur par l'intermédiaire d'une pluralité de séquences d'étapes, ou dans lequel chaque nœud radio fonctionne uniquement en tant qu'initiateur ou uniquement en tant que transpondeur par l'intermédiaire d'une pluralité de séquences d'étapes.

5. Procédé selon l'une quelconque des revendications précédentes, **caractérisé en ce qu'**un cycle de mesure est formé à partir de plusieurs répétitions de la séquence d'étapes, et la première séquence porteuse adopte respectivement une valeur prédéterminée à l'intérieur de la plage de fréquences pour chaque répétition au cours du cycle de mesure.

6. Procédé selon l'une quelconque des revendications précédentes, **caractérisé en ce qu'**une distance est déterminée entre ledit au moins un initiateur et ledit au moins un transpondeur sur la base de la fonction de transfert et/ou du décalage temporel.

7. Procédé selon l'une quelconque des revendications précédentes, **caractérisé en ce qu'**une analyse multivoie est effectuée pour au moins une fonction de transfert déterminée.

8. Procédé selon l'une quelconque des revendications précédentes, **caractérisé en ce qu'**un filtre est appliqué aux signaux de réponse reçus et/ou aux signaux initiaux reçus.

9. Procédé selon l'une quelconque des revendications précédentes, **caractérisé en ce qu'**une amplitude et/ou une phase du signal initial sont modifiées lors de chaque répétition en plus de la fréquence porteuse du signal initial.

10. Procédé selon l'une quelconque des revendications précédentes, **caractérisé en ce qu'**au moins trois nœuds radio sont prévus et, dans chaque séquence d'étapes, la seconde étape est répétée au moins une fois dans la première étape, dans lequel, dans la première étape, le signal initial est reçu par au moins deux nœuds radio qui fonctionne en tant que transpondeurs, dans chaque seconde étape, le signal de réponse est émis par exactement l'un des transpondeurs et est reçu par l'initiateur ainsi que par au moins un autre transpondeur et, lors de chaque répétition de la seconde étape, un autre transpondeur émet le signal de réponse et, dans le premier mode, lors de chaque répétition de la seconde étape, le signal de réponse est formé respectivement au moins à partir d'une partie du signal initial reçu ou à partir d'une partie du signal de réponse reçu.

11. Procédé selon l'une quelconque des revendications précédentes, **caractérisé en ce que** l'initiateur émet le signal initial au cours d'une première période d'émission et le transpondeur émet le signal de réponse au cours d'une seconde période d'émission, dans lequel la première période d'émission et la seconde période d'émission comprennent respectivement plusieurs fenêtres temporelles consécutives, l'émission ayant lieu respectivement uniquement au cours des fenêtres temporelles et deux fenêtres temporelles consécutives se succédant respectivement immédiatement dans le temps ou à une certaine distance l'une de l'autre dans le temps.

Fig. 1

Fig. 2

| Initiator TX BB Vector $V_I$ | Initiator TX HF Signal $T_I$ | Transponder RX BB Vector $R_T$ | Transponder TX BB Vector $V_T$ | Transponder TX HF Signal $T_T$ | Initiator RX BB Vector $R_I$ |
|---|---|---|---|---|---|
| Schritt S1 | | | Schritt S2 | | |
| 1 | $e^{j\omega_p t}$ | $G(j\omega_p) \cdot e^{j(\omega_p \cdot T'_{offs} - \Delta\varphi)}$ | 1 | $e^{j(\omega_p \cdot (t - T'_{offs} - T_{SV}) + \Delta\varphi)}$ | $G(j\omega_p) \cdot e^{-j(\omega_1 \cdot T'_{offs} - \Delta\varphi)}$ |
| | | | $V_T = R_T$ $= G(j\omega_p) \cdot$ $e^{j(\omega_p \cdot T'_{offs} - \Delta\varphi)}$ | $G(j\omega_p) \cdot$ $e^{j\omega_p \cdot (t - T_{SV})}$ | $G(j\omega_p) \cdot G(j\omega_p) =$ $mag^2(G(j\omega_p)) \cdot$ $e^{j \cdot 2 \cdot phase(G(j\omega_p))}$ |
| | | | $V_T = 1/R_T$ $= 1/G(j\omega_p) \cdot$ $e^{-j(\omega_p \cdot T'_{offs} - \Delta\varphi)}$ | $1/G(j\omega_p) \cdot$ $e^{j\omega_p \cdot (t - 2 \cdot T'_{offs} - T_{SV})} \cdot$ $e^{2 \cdot j\Delta\varphi}$ | $e^{-j \cdot 2 \cdot (\omega_p \cdot T'_{offs} - \Delta\varphi)}$ |
| | | | $V_T = conj(R_T)$ $= G^*(j\omega_p) \cdot$ $e^{-j(\omega_p \cdot T'_{offs} - \Delta\varphi)}$ | $G^*(j\omega_p) \cdot$ $e^{j\omega_p \cdot (t - 2 \cdot T'_{offs} - T_{SV})}$ $e^{2 \cdot j\Delta\varphi}$ | $mag^2(G(j\omega_p)) \cdot$ $e^{-j \cdot 2 \cdot (\omega_p \cdot T'_{offs} - \Delta\varphi)}$ |
| | | | $V_T = e^{j \cdot phase(R_T)}$ $= e^{j \cdot phase(G(j\omega_p))} \cdot$ $e^{j(\omega_p \cdot T'_{offs} - \Delta\varphi)}$ | $e^{j \cdot phase(G(j\omega_p))} \cdot$ $e^{j\omega_p (t - T_{SV})}$ | $mag(G(j\omega_p)) \cdot$ $e^{j \cdot 2 \cdot phase(G(j\omega_p))}$ |
| | | | $V_T = e^{-j \cdot phase(R_T)}$ $= e^{-j \cdot phase(G(j\omega_p))} \cdot$ $e^{-j(\omega_p \cdot T'_{offs} - \Delta\varphi)}$ | $e^{-j \cdot phase(G(j\omega_p))} \cdot$ $e^{j\omega_p \cdot (t - 2 \cdot T'_{offs} - T_{SV})} \cdot$ $e^{2 \cdot j\Delta\varphi}$ | $mag(G(j\omega_p)) \cdot$ $e^{-j \cdot 2 \cdot (\omega_p \cdot T'_{offs} - \Delta\varphi)}$ |

Fig. 3

Fig. 4

Fig. 5

Fig. 6

EP 3 635 992 B1

Fig. 7

Fig. 8

Fig. 9

Fig. 10

EP 3 635 992 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3243812 A
- DE 102009060505 B4
- DE 102009060593 A1
- DE 102009060592 B4
- DE 102009060591 A1
- WO 0201247 A2
- WO 2005119379 A1